# EUROPEAN PATENT SPECIFICATION

(11) **EP 3 316 282 B1**
(45) Date of publication and mention of the grant of the patent: **04.01.2023**
(21) Application number: 16834972.8
(22) Date of filing: 26.07.2016
(51) Int. Cl.: H01L 27/11573, H01L 27/11565, H01L 29/792, H01L 29/423, H01L 21/8234, H01L 27/092

(54) **SEMICONDUCTOR INTEGRATED CIRCUIT DEVICE PRODUCTION METHOD**
VERFAHREN ZUR HERSTELLUNG EINER INTEGRIERTEN HALBLEITERSCHALTVORRICHTUNG
PROCÉDÉ DE PRODUCTION DE DISPOSITIF DE CIRCUIT INTÉGRÉ SEMI-CONDUCTEUR

(30) Priority: 13.08.2015 JP 2015159875
(43) Date of publication of application: 02.05.2018
(73) Proprietor: Floadia Corporation, Kodaira-shi, Tokyo 187-0031 (JP)
(72) Inventor: OWADA Fukuo, Kodaira-shi Tokyo 187-0031 (JP); TANIGUCHI Yasuhiro, Kodaira-shi Tokyo 187-0031 (JP); KAWASHIMA Yasuhiko, Kodaira-shi Tokyo 187-0031 (JP); YOSHIDA Shinji, Kodaira-shi Tokyo 187-0031 (JP); KASAI Hideo, Kodaira-shi Tokyo 187-0031 (JP); SAKURAI Ryotaro, Kodaira-shi Tokyo 187-0031 (JP); SHINAGAWA Yutaka, Kodaira-shi Tokyo 187-0031 (JP); OKUYAMA Kosuke, Kodaira-shi Tokyo 187-0031 (JP)
(74) Representative: Bandpay & Greuter
(86) International application number: PCT/JP2016/071886
(87) International publication number: WO 2017/026275

(56) References cited:
- EP-A1- 3 291 292
- WO-A1-2016/060014
- JP-A- 2002 164 449
- JP-A- 2010 251 557
- JP-A- 2010 278 314
- US-A1- 2010 163 966
- US-A1- 2010 264 483
- US-A1- 2014 175 533

## Description

### Technical Field

The present invention relates to a method for producing semiconductor integrated circuit devices, and a semiconductor integrated circuit device.

### Background Art

In a conventional memory cell, a sidewall-shaped select gate electrode is disposed on a first sidewall of a memory gate electrode through a sidewall spacer made of an insulating member (for example, refer to Patent Literature 1). In another conventional memory cell, a memory gate electrode is disposed between a first select gate electrode and a second select gate electrode through a sidewall spacer to allow independent control of the first select gate electrode and the second select gate electrode. In such a memory cell, a charge storage layer is provided to a memory gate structure including the memory gate electrode. Data is programmed by injecting charge into the charge storage layer, and erased by removing charge from the charge storage layer.

In the latter memory cell, when charge is injected into the charge storage layer, a low bit voltage is applied to a channel layer below the memory gate structure through a first select gate structure including the first select gate electrode, while a second select gate structure including the second select gate electrode blocks source voltage. In this case, a high memory gate voltage is applied to the memory gate electrode of the memory gate structure, and charge is injected into the charge storage layer by a quantum tunneling effect due to a voltage difference between the bit voltage and the memory gate voltage.

In a semiconductor integrated circuit device in which memory cells each having such a configuration are disposed in a matrix of rows and columns, a memory gate line to which a high memory gate voltage is applied is shared by a plurality of memory cells. Thus, when a high memory gate voltage is applied to the memory gate line to inject charge into the charge storage layer of one memory cell, the high memory gate voltage is applied to the memory gate electrode of each of the other memory cells sharing the memory gate line while no charge is to be injected into the charge storage layer thereof.

To avoid this voltage application, in a memory cell in which no charge is to be injected in the charge storage layer, a high bit voltage is applied from a bit line to the channel layer of the memory gate structure through the first select gate structure while the second select gate structure connected to a source line blocks voltage application to the channel layer. Accordingly, a high bit voltage is applied to the channel layer of the memory gate structure in which a high memory gate voltage is applied to the memory gate electrode, leading to a reduced voltage difference between the memory gate electrode and the channel layer. As a result, no quantum tunneling effect occurs and no charge is injected into the charge storage layer.

For a plurality of memory cells disposed in such a matrix of rows and columns, a photolithography technique of fabricating a resist through a photomask, which is a typical semiconductor production process, is employed to fabricate, for example, a conductive layer through the resist, and produce the first select gate structure, the second select gate structure, and the memory gate structure.

### Citation List

### Patent Literature

Patent Literature 1: Japanese Patent Laid-Open No. 2011-129816

WO2016/060014 A1 discloses a semiconductor device, and a production method for said semiconductor device, in which a contact is provided so as to extend to a first selection gate electrode from the top of a contact installation structure having the same configuration as a memory gate structure. A conventional mounting section mounting the top of the memory gate structure is not formed, and thus the distance to an upper-layer wiring layer can be shortened, the aspect ratio can be reduced, and, as a result, an increase in the contact resistance value can be inhibited. Furthermore, the conventional mounting section mounting the top of the memory gate structure is not formed, and thus the contact installation structure and the upper-layer wiring layer can be kept apart, and, as a result, contact failure with the upper-layer wiring layer can be inhibited.

US2010/163966 A1 discloses a flash memory device and a method for manufacturing the same. The flash memory device includes first and second memory gates on a substrate; a floating poly between the first and second memory gates; first and second select gates at respective outer sides of the first and second memory gates; an oxide layer between the first memory gate and the first select gate and between the second memory gate and the second select gate; a drain region in the substrate at outer sides of the first and second select gates; a source region in the substrate between the first and second memory gates; and a metal contact on each of the drain region and the source region.

US2010/264483 A1 discloses semiconductor storage device and method of manufacturing same at a lower cost by without forming a photolithographic resist. Second impurity regions are arranged in such a manner that second impurity regions adjacent along the column direction are joined together. A select gate electrode is

### Summary of Invention

### Technical Problem

Such a semiconductor integrated circuit device includes, in addition to a plurality of memory cells disposed in a matrix of rows and columns, peripheral circuits such as a central processing unit (CPU), an application-specific integrated circuit (ASIC), a sense amplifier, a column decoder, a row decoder, and an input and output circuit. Thus, production of the memory cells disposed in the matrix requires an extra semiconductor production process of producing the memory cells in addition to a semiconductor production process of producing the peripheral circuits.

In particular, each memory cell described above has a special configuration in which the first select gate electrode and the second select gate electrode are independently controllable. Accordingly, an extra dedicated photomask process using a photomask dedicated to fabrication of a memory circuit region only is needed in addition to a conventional dedicated photomask process of fabricating a memory circuit region only, which leads to increase in production cost.

The present invention has been made under such circumstances and aims at providing a method for producing semiconductor integrated circuit devices, and a arranged into a ring shape so as to surround the second impurity regions and is electrically connected to a word line. A first control gate electrode is arranged into a ring shape on the outer peripheral side of the select gate electrode, and a second control gate electrode is arranged into a ring shape on the inner peripheral side of the select gate electrode. A pair of first and second bit lines corresponding to every row are placed on the memory cells of the device, a first bit line is electrically connected to one of first impurity regions that are adjacent along the row direction, and a second bit line is electrically connected to the other of the first impurity regions that are adjacent along the row direction.
semiconductor integrated circuit device, that achieve reduction in production cost.

### Solution to Problem

In order to solve the above-described problems, a method for producing a semiconductor integrated circuit device of the present invention **according to claim 1** is **provided.**

**The method according to the present invention produces** a semiconductor integrated circuit device **that** includes a memory circuit region including a memory cell in which a memory gate structure is disposed between a first select gate structure and a second select gate structure through a sidewall spacer, the first select gate structure including a first select gate electrode, the second select gate structure including a second select gate electrode, and a peripheral circuit region including a logic gate structure of a peripheral circuit. The logic gate structure has a configuration in which a logic gate electrode made of a conductive layer same as a conductive layer of the first select gate electrode and the second select gate electrode is disposed on a gate insulating film. The memory gate structure has a configuration in which a lower gate insulating film, a charge storage layer, an upper gate insulating film, and a memory gate electrode are stacked in this order. The first select gate electrode and the second select gate electrode are sidewall-shaped along the sidewall spacer on a sidewall of the memory gate electrode, and electrically separated from each other by a plurality of select gate electrode cutout portions at which the first select gate electrode and the second select gate electrode are absent.

### [Advantageous Effects of Invention]

According to the present invention, in a photomask process of forming a logic gate electrode in a peripheral circuit region, part of a conductive layer in a select gate electrode cutout planned region in a memory circuit region is removed in advance. Thereafter, when the conductive layer in the memory circuit region is etched back to form a first select gate electrode and a second select gate electrode, the conductive layer remaining in the select gate electrode cutout planned region is removed to form a select gate electrode cutout portion that electrically separates the first select gate electrode and the second select gate electrode from each other. Accordingly, when the first select gate electrode and the second select gate electrode that are independently controllable are formed in a production process for a semiconductor integrated circuit device, an extra dedicated photomask process for electrically separating the first select gate electrode and the second select gate electrode from each other is not needed in addition to a conventional dedicated photomask process of fabricating a memory circuit region only, thereby achieving reduction in a production cost accordingly.

### Brief Description of Drawings

FIG. 1 is a schematic view illustrating a planar layout of a semiconductor integrated circuit device produced by a production method of the present invention.
FIG. 2 is a cross-sectional view illustrating a cross section taken along line A-A' in FIG. 1.
FIG. 3 is a cross-sectional view illustrating a cross section taken along line B-B' in FIG. 1.
FIG. 4 is a cross-sectional view illustrating a cross section taken along line C-C' in FIG. 1.
FIG. 5A is a schematic view illustrating production step (1) for a semiconductor integrated circuit device; FIG. 5B is a schematic view illustrating production step (2) for a semiconductor integrated circuit device; and FIG. 5C is a schematic view illustrating production step (3) for a semiconductor integrated circuit device.
FIG. 6A is a schematic view illustrating production step (4) for a semiconductor integrated circuit device; FIG. 6B is a schematic view illustrating production step (5) for a semiconductor integrated circuit device; and FIG. 6C is a schematic view illustrating production step (6) for a semiconductor integrated circuit device.
FIG. 7A is a schematic view illustrating production step (7) for a semiconductor integrated circuit device; FIG. 7B is a schematic view illustrating production step (8) for a semiconductor integrated circuit device; and FIG. 7C is a schematic view illustrating production step (9) for a semiconductor integrated circuit device.
FIG. 8 is a schematic view illustrating production step (10) for a semiconductor integrated circuit device.
FIG. 9 is a schematic view illustrating a state in which resists used to form a remaining conductive layer in select gate electrode cutout planned regions and logic gate electrodes are placed over the planar layout of the completed semiconductor integrated circuit device illustrated in FIG. 1.
FIG. 10A is a schematic view illustrating production step (11) for a semiconductor integrated circuit device; and FIG. 10B is a schematic view illustrating production step (12) for a semiconductor integrated circuit device.
FIG. 11 is a schematic view illustrating a state in which resists used to form first select gate electrodes, second select gate electrodes, select gate electrode cutout portions, and contact formation conductive layers are placed over the planar layout of the completed semiconductor integrated circuit device illustrated in FIG. 1.
FIG. 12A is a schematic view illustrating production step (13) for a semiconductor integrated circuit device; FIG. 12B is a schematic view illustrating production step (14) for a semiconductor integrated circuit device; and FIG. 12C is a schematic view illustrating production step (15) for a semiconductor integrated circuit device.

### Description of Embodiments

Hereinafter, embodiments of the present invention will be described in the following order.
<1. Configuration of semiconductor integrated circuit device produced by production method of the present invention>
   1-1. Planar layout of semiconductor integrated circuit device
   1-2. Sections of sites of semiconductor integrated circuit device
   1-3. Data programming method
<2. Method for producing semiconductor integrated circuit devices>
<3. Operations and effects>
<4. Production methods according to other embodiments without third photomask fabrication step>
<5. Other embodiments>
   (1) Configuration of semiconductor integrated circuit device produced by production method of the present invention
      (1-1) Planar layout of semiconductor integrated circuit device

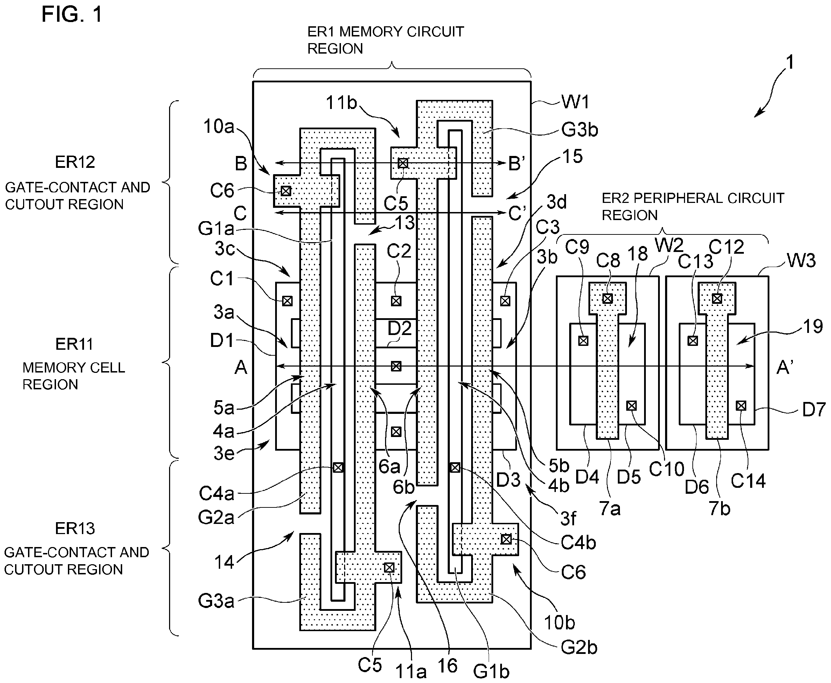

FIG. 1 is a schematic view illustrating a planar layout of a completed semiconductor integrated circuit device 1 produced by a production method of the present invention. FIG. 1 mainly illustrates a planar layout of memory gate structures 4a and 4b, first select gate structures 5a and 5b, and second select gate structures 6a and 6b, which are disposed in a memory circuit region ER1. FIG. 1 also mainly illustrates a planar layout of logic gate structures 7a and 7b disposed in a peripheral circuit region ER2. FIG. 1 omits illustrations of, for example, a sidewall spacer disposed on each sidewall of the memory gate structures 4a and 4b, any sidewall structure formed in the first select gate structures 5a and 5b and the second select gate structures 6a and 6b, and any element separation layer disposed in a memory well W1 and logic wells W1 and W2, which will be described later.

The semiconductor integrated circuit device 1 includes the memory circuit region ER1 and the peripheral circuit region ER2 on a semiconductor substrate (not illustrated). For example, the P-type memory well W1 is disposed in the memory circuit region ER1, whereas the P-type logic well W2 and the N-type logic well W3 are disposed in the peripheral circuit region ER2.

The memory circuit region ER1 includes a memory cell region ER11 between gate-contact and cutout regions ER12 and ER13. The memory cell region ER11 includes a plurality of memory cells 3a, 3b, 3c, 3d, 3e, and 3f disposed in a matrix of rows and columns. The memory cells 3a, 3b, 3c, 3d, 3e, and 3f all have identical configurations, and thus the following description will be made mainly on the memory cells 3a and 3b disposed along line A-A'.

The memory cell 3a has a configuration in which the memory gate structure 4a is disposed between the first select gate structure 5a and the second select gate structure 6a through a sidewall spacer (not illustrated). In the present embodiment, the memory gate structure 4a, which forms the memory cells 3a, 3c, and 3e of the first column, and the memory gate structure 4b, which forms the remaining memory cells 3b, 3d, and 3f of the second column, are shaped in straight lines parallel to each other. A contact C4a (C4b) is vertically provided on the memory gate structure 4a (4b) and connected to a memory gate line (not illustrated) to allow application of a memory gate voltage from the memory gate line through the contact C4a (C4b).

In the memory cell region ER11, the first select gate structure 5a (5b) and the second select gate structure 6a (6b) are shaped in straight lines parallel to the memory gate structure 4a (4b) including a memory gate electrode G1a (G1b). The first select gate structure 5a (5b) includes a first select gate electrode G2a (G2b). The second select gate structure 6a (6b) includes a second select gate electrode G3a (G3b). The first select gate electrode G2a (G2b) and the second select gate electrode G3a (G3b) are sidewall-shaped along a sidewall spacer on a sidewall of the memory gate electrode G1a (G1b), disposed on an identical line surrounding the memory gate electrode G1a (G1b), and electrically separated from each other through a plurality of select gate electrode cutout portions 13 and 14 (15 and 16) at which the first select gate electrode G2a (G2b) and the second select gate electrode G3a (G3b) are not formed.

Two source regions D1 and D3 are symmetrically disposed at an interval therebetween on a surface (substrate surface) of the memory well W1 in the memory cell region ER11, and a plurality of drain regions D2 are disposed between the source regions D1 and D3. In the memory cell region ER11, the memory cells 3a, 3c, and 3e of the first column, in which the memory gate structure 4a is disposed between the first select gate structure 5a and the second select gate structure 6a, are disposed between the source region D1 and the drain regions D2. The memory cells 3b, 3d, and 3f of the second column, in which the memory gate structure 4b is disposed between the second select gate structure 6b and the first select gate structure 5b, are disposed between the drain regions D2 and the source region D3. The memory cells 3a, 3c, and 3e and the memory cells 3b, 3d, and 3f are symmetrically disposed with respect to the drain regions D2.

The source region D1 on the surface of the memory well W1 is disposed along the first select gate structure 5a and extends to regions adjacent to the first select gate structure 5a in accordance with the positions of the memory cells 3a, 3c, and 3e of the first column. The source region D1 is shared by the memory cells 3a, 3c, and 3e arranged in line. A contact C1 is connected to a source line (not illustrated) and vertically provided on the source region D1 to allow application of a source voltage from the source line through the contact C1.

The drain regions D2 on the surface of the memory well W1 between the second select gate structures 6a and 6b are disposed in regions adjacent to the second select gate structures 6a and 6b in accordance with the positions of the memory cells 3a and 3b (3c and 3d; 3e and 3f) adjacent to the drain regions D2, respectively. The drain region D2 is shared by the adjacent memory cells 3a and 3b (3c and 3d; 3e and 3f). A contact C2 is connected to a bit line (not illustrated) and vertically provided on the drain region D2 to allow application of a bit voltage through the contact C2 from the bit line. In FIG. 1, the bit line (not illustrated) is shared by the memory cells 3a and 3b (3c and 3d; or 3e and 3f) arranged in a row direction to allow application of an identical bit voltage to the memory cells 3a and 3b (3c and 3d; or 3e and 3f) within a row.

The source region D3 on the surface of the memory well W1 is symmetrical to the source region D1, and similarly to the source region D1, extends to regions adjacent to the first select gate structure 5b. The source region D3 is shared by the memory cells 3b, 3d, and 3f of the second column. A contact C3 is vertically provided on the source region D3 and connected to the same source line for the source region D1. Accordingly, an identical source voltage is applied through the contacts C1 and C3 to the memory cells 3a, 3b, 3c, 3d, 3e, and 3f disposed in the memory cell region ER11.

The two memory gate electrodes G1a and G1b, which are parallel to each other in the memory cell region ER11, extend in straight lines parallel to each other in the gate-contact and cutout region ER12 and the gate-contact and cutout region ER13 adjacent to the memory cell region ER11. The memory gate electrodes G1a and G1b each have one end disposed in the gate-contact and cutout region ER12 and the other end disposed in the gate-contact and cutout region ER13.

In the present embodiment, the first select gate electrode G2a, the memory gate electrode G1a, and the second select gate electrode G3a included in the memory cells 3a, 3c, and 3e of the first column are symmetrical to the second select gate electrode G3b, the memory gate electrode G1b, and the first select gate electrode G2b included in the memory cells 3b, 3d, and 3f of the second column. Thus, the following description of the gate-contact and cutout regions ER12 and ER13 will be made with the first select gate electrode G2a, the memory gate electrode G1a, and the second select gate electrode G3a included in the memory cells 3a, 3c, and 3e of the first column.

The gate-contact and cutout region ER12 includes a contact formation conductive layer 10a at a position on the first select gate electrode G2a extending from the memory cell region ER11, and also includes the select gate electrode cutout portion 13 separating the first select gate electrode G2a and the second select gate electrode G3a from each other.

In the present embodiment, the contact formation conductive layer 10a is disposed at a halfway position of the first select gate electrode G2a in the gate-contact and cutout region ER12. In the gate-contact and cutout region ER12, the first select gate electrode G2a extends from the contact formation conductive layer 10a in a direction departing from the memory cell region ER11, and then bends around one end of the memory gate electrode G1a so that an end of the first select gate electrode G2a is disposed on a side where the corresponding second select gate electrode G3a is disposed.

The gate-contact and cutout region ER12 includes an end of the second select gate electrode G3a extending from the memory cell region ER11. The end of the first select gate electrode G2a and the end of the second select gate electrode G3a face each other at a predetermined distance on an identical straight line to form the select gate electrode cutout portion 13 across which the first select gate electrode G2a and the second select gate electrode G3a are separated from each other.

A contact C6 connected to a first select gate line (not illustrated) is vertically provided on the contact formation conductive layer 10a. When receiving a first select gate voltage from the first select gate line through the contact C6, the contact formation conductive layer 10a allows application of the first select gate voltage only to the first select gate electrode G2a.

The gate-contact and cutout region ER13 includes a contact formation conductive layer 11a at a position on the second select gate electrode G3a extending from the memory cell region ER11, and also includes the select gate electrode cutout portion 14 separating the first select gate electrode G2a and the second select gate electrode G3a.

In the present embodiment, in the gate-contact and cutout region ER13, the second select gate electrode G3a extends from the contact formation conductive layer 11a in a direction departing from the memory cell region ER11, and then bends around the other end of the memory gate electrode G1a so that an end of the second select gate electrode G3a is disposed on a side where the corresponding first select gate electrode G2a is disposed.

The gate-contact and cutout region ER13 includes an end of the first select gate electrode G2a extending from the memory cell region ER11. The end of the first select gate electrode G2a and the end of the second select gate electrode G3a face each other at a predetermined distance on an identical straight line to form the select gate electrode cutout portion 14 across which the first select gate electrode G2a and the second select gate electrode G3a are separated from each other.

A contact C5 connected to a second select gate line (not illustrated) is vertically provided on the contact formation conductive layer 11a. When receiving a second select gate voltage from the second select gate line through the contact C5, the contact formation conductive layer 11a allows application of the second select gate voltage only to the second select gate electrode G3a.

Accordingly, in the memory circuit region ER1, the first select gate electrode G2a, which is continuous with the contact formation conductive layer 10a, is electrically separated from the second select gate electrode G3a, which is continuous with the contact formation conductive layer 11a, through the select gate electrode cutout portions 13 and 14. This electrical separation allows independent control of the first select gate electrode G2a and the second select gate electrode G3a.

In the gate-contact and cutout regions ER12 and ER13, the second select gate electrode G3b, the memory gate electrode G1b, and the first select gate electrode G2b on the second column have configuration same as those of the first select gate electrode G2a, the memory gate electrode G1a, and the second select gate electrode G3a on the first column described above. However, the gate-contact and cutout region ER12 includes a contact formation conductive layer 11b at a position on the second select gate electrode G3b, and the select gate electrode cutout portion 15, across which the first select gate electrode G2b and the second select gate electrode G3b are separated from each other, is provided on a side where the first select gate electrode G2b is disposed, which are differences.

In addition, the gate-contact and cutout region ER13 includes a contact formation conductive layer 10b at a position on the first select gate electrode G2b, and the select gate electrode cutout portion 16, across which the first select gate electrode G2b and the second select gate electrode G3b are separated from each other, is provided on a side where the second select gate electrode G3b is disposed, which are other differences.

Thus, in the configuration including the second select gate electrode G3b, the memory gate electrode G1b, and the first select gate electrode G2b, the first select gate electrode G2b is electrically separated from the second select gate electrode G3b through the select gate electrode cutout portions 15 and 16 provided between the first select gate electrode G2b, which is continuous with the contact formation conductive layer 10b, and the second select gate electrode G3b, which is continuous with the contact formation conductive layer 11b. This electrical separation allows independent control of the first select gate electrode G2b and the second select gate electrode G3b.

The following describes the peripheral circuit region ER2 adjacent to the memory circuit region ER1 with the above-described configuration. In the present embodiment, the peripheral circuit region ER2 is disposed at a position adjacent to the memory cell region ER11 of the memory circuit region ER1, but the present invention is not limited this configuration. The peripheral circuit region ER2 may be disposed at various positions such as a position adjacent to the gate-contact and cutout region ER12, a position adjacent to the gate-contact and cutout region ER13, and a position adjacent to a region between the memory cell region ER11 and the gate-contact and cutout region ER12.

A plurality of peripheral circuits 18 and 19 are disposed in the peripheral circuit region ER2. The peripheral circuit 18 has, for example, an N-type metaloxide-semiconductor (MOS) transistor structure in the P-type logic well W2. In such a case, the logic well W2 includes a logic gate structure 7a to allow application of a logic gate voltage to the logic gate structure 7a through a contact C8.

In the logic well W2, impurity diffusion regions D4 and D5 are disposed in regions adjacent to the logic gate structure 7a with the logic gate structure 7a interposed therebetween. A contact C9 is vertically provided on the impurity diffusion region D4, whereas a contact C10 is vertically provided on the impurity diffusion region D5.

The peripheral circuit 19 has, for example, a P-type MOS transistor structure in the N-type logic well W3. In such a case, the logic well W3 includes a logic gate structure 7b to allow application of a logic gate voltage to the logic gate structure 7b through a contact C12.

In the logic well W3, impurity diffusion regions D6 and D7 are disposed in regions adjacent to the logic gate structure 7B with the logic gate structure 7b interposed therebetween. A contact C13 is vertically provided on the impurity diffusion region D6, whereas a contact C14 is vertically provided on the impurity diffusion region D7.

### (1-2) Sections of sites of semiconductor integrated circuit device

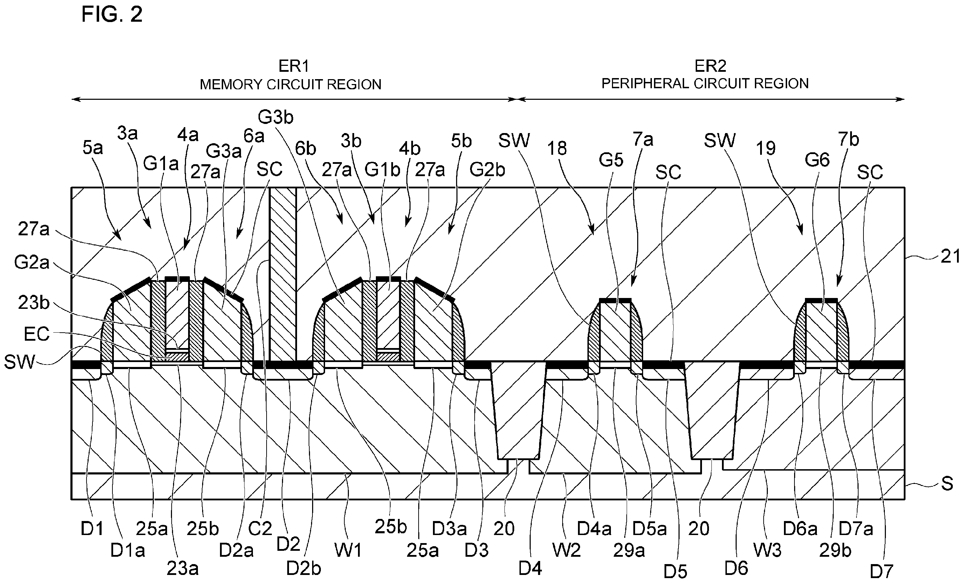

FIG. 2 is a cross-sectional view illustrating cross sections of the memory cells 3a and 3b in the memory cell region ER11 and the peripheral circuits 18 and 19 in the peripheral circuit region ER2, taken along line A-A' in FIG. 1. The semiconductor integrated circuit device 1 includes the semiconductor substrate S. The memory well W1 is disposed on the semiconductor substrate S in the memory circuit region ER1, and the logic wells W2 and W3 are disposed on the semiconductor substrate S in the peripheral circuit region ER2.

In the present embodiment, in the memory well W1, the two memory cells 3a and 3b are disposed on line A-A', and the drain regions D2, on each of which the contact C2 is vertically provided, are disposed on the surface between the memory cells 3a and 3b. Since the memory cells 3a and 3b are symmetrically disposed but have identical configurations, the memory cell 3a will be described below.

In the memory well W1, the memory cell 3a includes, for example, the memory gate structure 4a having an N-type transistor structure, the first select gate structure 5a having an N-type MOS transistor structure, and the second select gate structure 6a having an N-type MOS transistor structure.

The source region D1 and each drain region D2 are spaced at a distance on the surface of the memory well W1. A source voltage from a source line is applied to the source region D1 through the contact C1 (FIG. 1), and a bit voltage from a bit line is applied to the drain region D2 through the contact C2. In the present embodiment, impurity concentration is 1.0E21/cm³ or more in each of the source region D1 and the drain region D2. In the memory well W1, the impurity concentration of a surface region (for example, a region extending to a depth of 50 nm from the surface) in which a channel layer is formed is 1.0E19/cm³ or less, preferably is 3.0E18/cm³ or less, through impurity implantation performed in a production process.

The memory gate structure 4a includes a charge storage layer EC containing, for example, silicon nitride (Si₃N₄), silicon oxynitride (SiON), or alumina (Al₂O₃) on the memory well W1 between the source region D1 and the drain region D2 through a lower gate insulating film 23a made of an insulating member such as SiO₂. The memory gate structure 4a further includes the memory gate electrode G1a on the charge storage layer EC through an upper gate insulating film 23b made of an insulating member such as SiO₂. The lower gate insulating film 23a and the upper gate insulating film 23b of the memory gate structure 4a insulate the charge storage layer EC from the memory well W1 and the memory gate electrode G1a.

A sidewall spacer 27a made of an insulating material is disposed along a first sidewall of the memory gate structure 4a and adjacent to the first select gate structure 5a through the sidewall spacer 27a. The memory gate structure 4a is adjacent to the first select gate structure 5a through the sidewall spacer 27a. This sidewall spacer 27a, which is disposed between the memory gate structure 4a and the first select gate structure 5a, has a thickness enough to insulate the memory gate structure 4a from the first select gate structure 5a.

The first select gate structure 5a includes a gate insulating film 25a made of an insulating member on the memory well W1 between the sidewall spacer 27a and the source region D1. The gate insulating film 25a has a thickness of less than or equal to 9 nm, preferably less than or equal to 3 nm. The first select gate electrode G2a, to which the first select gate line is connected, is disposed on the gate insulating film 25a.

The sidewall spacer 27a made of an insulating member is disposed along a second sidewall of the memory gate structure 4a. The memory gate structure 4a is adjacent to the second select gate structure 6a through the sidewall spacer 27a. This sidewall spacer 27a, which is disposed between the memory gate structure 4a and the second select gate structure 6a, has a thickness same as that of the sidewall spacer 27a between the memory gate structure 4a and the first select gate structure 5a, which is enough to insulate the memory gate structure 4a from the second select gate structure 6a.

The second select gate structure 6a includes a gate insulating film 25b made of an insulating member on the memory well W1 between the sidewall spacer 27a and the drain regions D2. The gate insulating film 25b has a thickness of less than or equal to 9 nm, preferably less than or equal to 3 nm. The second select gate electrode G3a, to which the second select gate line is connected, is disposed on the gate insulating film 25b.

The first select gate electrode G2a and the second select gate electrode G3a, which are disposed along the sidewall of the memory gate electrode G1a through the sidewall spacer 27a, are formed by etching back through a production process to be described later. The first select gate electrode G2a and the second select gate electrode G3a each have a sidewall shape in which the height of the first select gate electrode G2a or the second select gate electrode G3a decreases the distance from the memory gate electrode G1a such that the top portion of the first select gate electrode G2a or the second select gate electrode G3a slopes down toward the memory well W1.

A sidewall structure SW made of an insulating member is disposed on each of the sidewall of the first select gate structure 5a and the sidewall of the second select gate structure 6a. An extension region D1a is disposed in a region of a surface of the memory well W1 below one of the sidewall structures SW, and an extension region D2a is disposed in a region of the surface of the memory well W1 below the other sidewall structure SW.

In the present embodiment, when impurity concentration is 1E19/cm³ or less in a region extending to a depth of 50 nm from the surface of the memory well W1 between the first select gate electrode G2a and the second select gate electrode G3a, the gate insulating films 25a and 25b are each formed to have a thickness of less than or equal to 9 nm through a subsequent production step. When impurity concentration is 3E18/cm³ or less in a region extending to a depth of 50 nm from the surface of the memory well W1 between the first select gate electrode G2a and the second select gate electrode G3a, the gate insulating films 25a and 25b are each formed to have a thickness of less than or equal to 3 nm through a subsequent production step.

The memory cell 3b has a configuration similar to the memory cell 3a. The memory cell 3b includes the memory gate structure 4b on the memory well W1 between the source region D3 and the drain regions D2. The memory gate structure 4b is disposed on the memory well W1 between the first select gate structure 5b and the second select gate structure 6b through the sidewall spacer 27a. In the memory cell 3b, too, an extension region D3a is disposed in a region of the surface of the memory well W1 below the sidewall structure SW formed on the sidewall of the first select gate structure 5b, whereas an extension region D2b is disposed in a region of the surface of the memory well W1 below the sidewall structure SW formed on the sidewall of the second select gate structure 6b.

The memory well W1 disposed in the memory circuit region ER1 is electrically insulated from the logic well W2 disposed in the peripheral circuit region ER2 by an element separation layer 20. The logic well W2 disposed in the peripheral circuit region ER2 is electrically insulated from the logic well W3 by another element separation layer 20. In the present embodiment, the peripheral circuit 18 having an N-type MOS transistor structure is disposed in the logic well W2, whereas the peripheral circuit 19 having a P-type MOS transistor structure is disposed in the logic well W3.

The logic gate structure 7a in the logic well W2 includes a logic gate electrode G5 disposed through a gate insulating film 29a between a pair of the impurity diffusion regions D4 and D5 disposed on the surface. The sidewall structure SW is disposed on a sidewall of the logic gate structure 7a. Extension regions D4a and D5a are disposed in regions of the logic well W2 surface below the respective sidewall structures SW.

The logic well W3, which has a conduction type different from that of the logic well W2, has a configuration similar to that of the logic well W2. The logic gate structure 7b in the logic well W3 includes a logic gate electrode G6 disposed through a gate insulating film 29b between a pair of the impurity diffusion regions D6 and D7 in the surface. The sidewall structure SW is disposed on a sidewall of the logic gate structure 7b. Extension regions D6a and D7a are disposed in regions of the logic well W2 surface below the respective sidewall structures SW.

An insulating layer 21 covers sites such as the first select gate structures 5a and 5b, the memory gate structures 4a and 4b, the second select gate structures 6a and 6b, the contact C2, and the logic gate structures 7a and 7b of the semiconductor integrated circuit device 1 so as to insulate these sites from each other. Silicide SC covers surfaces of other various sites such as the source regions D1 and D3 and the drain region D2.

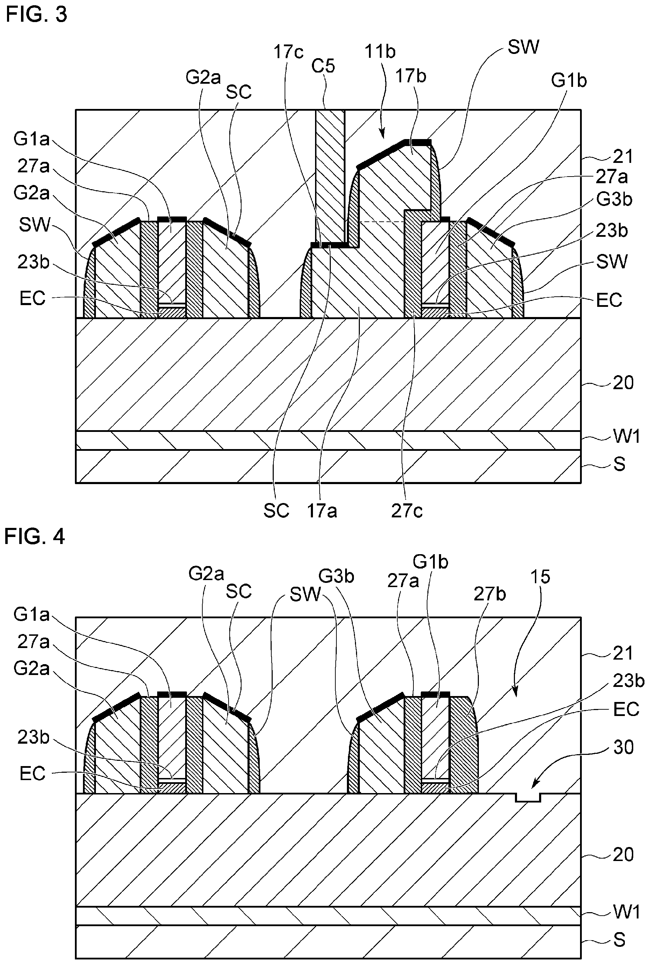

FIG. 3 is a cross-sectional view illustrating a cross section of the contact formation conductive layer 11b provided to the second select gate electrode G3b in the gate-contact and cutout region ER12 of the memory circuit region ER1, which is taken along line B-B' in FIG. 1. As illustrated in FIG. 3, the contact formation conductive layer 11b is disposed on the element separation layer 20 in the memory well W1.

The contact formation conductive layer 11b mounts across one sidewall of the memory gate electrode G1b and part of a top portion of the memory gate electrode G1b from a surface (substrate surface) of the element separation layer 20. A contact installation surface 17c having a flat shape in accordance with the surface shape of the element separation layer 20 is disposed on a base 17a disposed on the element separation layer 20. A sidewall spacer 27c is disposed between the contact formation conductive layer 11b and the memory gate electrode G1b to insulate the contact formation conductive layer 11b from the memory gate electrode G1b.

The column-shaped contact C5 is vertically provided on the contact installation surface 17c of the contact formation conductive layer 11b through the silicide SC. The second select gate voltage is applied through the contact C5. Accordingly, the second select gate voltage is applied to the second select gate electrode G3b through the contact formation conductive layer 11b. The sidewall structure SW is disposed on a sidewall of the base 17a of the contact formation conductive layer 11b and a sidewall of a mounting portion 17b on the top portion of the memory gate electrode G1b, which is integrated with the base 17a.

In the present embodiment, as illustrated in FIG. 1, the second select gate electrode G3b, on which the contact formation conductive layer 11b is disposed, bends around one end of the memory gate electrode G1b so that an end of the second select gate electrode G3b face the contact formation conductive layer 11b with the memory gate electrode G1b interposed therebetween. Thus, in FIG. 3, which illustrates a cross section taken along line B-B' in FIG. 1, the contact formation conductive layer 11b faces the second select gate electrode G3b provided continuously with the contact formation conductive layer 11b and bending around one end of the memory gate electrode G1b, through the memory gate electrode G1b and the sidewall spacers 27a and 27c.

As illustrated in FIG. 3, since the first select gate electrode G2a bends around the one end of the memory gate electrode G1a on a side where the memory gate electrode G1a is disposed (FIG. 1), the first select gate electrode G2a face itself through the memory gate electrode G1a and the sidewall spacer 27a along line B-B' in FIG. 1.

FIG. 4 is a cross-sectional view illustrating a cross section of the select gate electrode cutout portion 15 in the gate-contact and cutout region ER12 of the memory circuit region ER1, which is taken along line C-C' in FIG. 1. As illustrated in FIG. 4, in a region (region on the right side in FIG. 4) in which the select gate electrode cutout portion 15 is disposed, the second select gate electrode G3b is formed on the one sidewall of the memory gate electrode G1b through the sidewall spacer 27a. In this region, however, the first select gate electrode G2b and the second select gate electrode G3b are not disposed on another sidewall of the memory gate electrode G1b, but only an insulation wall 27b including a sidewall spacer and a sidewall structure is disposed on the other sidewall.

In the region in which the select gate electrode cutout portion 15 is disposed, a recess 30 is formed on a surface of the element separation layer 20 by removing part of a substrate surface through a production process. In the present embodiment, the first select gate electrode G2a faces itself through the memory gate electrode G1a and the sidewall spacer 27a along line C-C' in FIG. 1 on the side where the memory gate electrode G1a is disposed.

### (1-3) Data programming method

A data programming operation is performed on the memory cell 3a thus configured by any one of a first programming method and a second programming method. In the first programming method, before execution of the data programming operation, carriers that form a channel layer are removed from a region (hereinafter referred to as a channel layer formation carrier region) in which the carriers exist in the memory well W1 facing the memory gate electrode G1a (hereinafter, this operation is referred to as a carrier removing operation). In the second programming method, the data programming operation is executed without the carrier removing operation.

### (1-3-1) First programming method

In the first programming method, at execution of the carrier removing operation, for example, a second select gate voltage of 1.5 V is applied from the second select gate line to the second select gate electrode G3a of the second select gate structure 6a illustrated in FIG. 2, and a bit voltage of 0 V is applied from the bit line to the drain region D2. Accordingly, the surface of the memory well W1 facing the second select gate electrode G3a of the second select gate structure 6a becomes a conductive state to electrically connect the drain region D2, which is connected with the bit line, and the channel layer formation carrier region in the memory well W1 facing the memory gate structure 4a.

In the present embodiment, for example, a first select gate voltage of 1.5 V is applied from the first select gate line to the first select gate electrode G2a of the first select gate structure 5a, and a source voltage of 0 V is applied from the source line to the source region D1. Accordingly, the surface of the memory well W1 facing the first select gate electrode G2a of the first select gate structure 5a becomes a conductive state to electrically connect the source region D1, which is connected with the source line, and the channel layer formation carrier region in the memory well W1 facing the memory gate structure 4a.

In addition, in the memory cell 3a, for example, a substrate voltage of 0 V, which is equal to the bit voltage and the source voltage is applied to the memory well W1, and a carrier removal voltage of -2 V is applied from the memory gate line to the memory gate electrode G1a of the memory gate structure 4a. The carrier removal voltage applied to the memory gate electrode G1a is defined with respect to a threshold voltage (Vth) at which a channel layer is formed in the memory well W1 facing the memory gate structure 4a. In this case, the carrier removal voltage has a voltage value that differs out of a range of the threshold voltage (Vth) between a data programmed state and a data erased state and forms no channel layer when applied to the memory gate electrode G1a.

Accordingly, in the memory cell 3a, carriers (in this case, electrons) induced in the channel layer formation carrier region are expelled from the channel layer formation carrier region into the drain region D2 and /or the source region D1 by the carrier removal voltage applied to the memory gate electrode G1a. As a result, no channel layer is formed in the memory well W1 directly below the memory gate structure 4a, and minority carriers are depleted in the memory cell 3a.

In the memory cell 3a, the carrier removal voltage lower (shallower) than a lower (shallower) threshold voltage when the charge storage layer EC stores no electrons (or stores holes) is applied to the memory gate electrode G1a. Thereby, even if the memory cell 3a is in the depleted state, carriers induced in the channel layer formation carrier region of the memory well W1 directly below the memory gate structure 4a are excluded from the channel layer formation carrier region. Accordingly, no channel layer is formed and minority carriers are depleted in the memory cell 3a.

Thereafter, when charge is injected into the charge storage layer EC of the memory cell 3a, a charge storage gate voltage of 12 V is applied from the memory gate line to the memory gate electrode G1a of the memory gate structure 4a. In this case, a gate off voltage of 0 V is applied from the first select gate line to the first select gate electrode G2a of the first select gate structure 5a, and a source off voltage of 0 V is applied from the source line to the source region D1. Accordingly, electrical connection is blocked between the source region D1, which is connected with the source line, and the channel layer formation carrier region of the memory gate structure 4a, and voltage application is prevented from the source line to the channel layer formation carrier region of the memory gate structure 4a.

Since the second select gate voltage of 1.5 V is applied from the second select gate line to the second select gate electrode G3a of the second select gate structure 6a and the charge storage bit voltage of 0 V is applied from the bit line to the drain region D2, the drain region D2, which is connected with the bit line, and the channel layer formation carrier region of the memory gate structure 4a are electrically connected with each other. Simultaneously, the substrate voltage of 0 V, which is equal to the charge storage bit voltage, is applied to the memory well W1.

The electrical connection between the drain region D2 and the channel layer formation carrier region of the memory well W1 below the memory gate structure 4a allows carriers to be induced into the channel layer formation carrier region to form a channel layer at 0 V, which is equal to the charge storage bit voltage, in the surface of the memory well W1. Accordingly, a large voltage difference of 12 V is generated between the memory gate electrode G1a of the memory gate structure 4a and the channel layer to cause the quantum tunneling effect, which allows charge injection into the charge storage layer EC, thereby achieving a data programmed state.

When charge is not to be injected into the charge storage layer EC of the memory cell 3a at application of the high charge storage gate voltage to the memory gate electrode G1a, no high voltage bit voltage needs to be applied to the bit line in accordance with the high charge storage gate voltage as conventional cases. The charge injection into the charge storage layer EC of the memory gate structure 4a is prevented by blocking, through the second select gate structure 6a, the electrical connection between the bit line and the channel layer formation carrier region of the memory well W1 directly below the memory gate structure 4a and blocking, through the first select gate structure 5a, the electrical connection between the source line and the channel layer formation carrier region directly below the memory gate structure 4a.

In the memory cell 3a to which no data is to be programmed, for example, a second select gate voltage of 1.5 V is applied from the second select gate line to the second select gate electrode G3a, and an off voltage of 1.5 V is applied from the bit line to the drain region D2. Accordingly, the second select gate structure 6a becomes a non-conductive state (off state) to block the electrical connection between the drain region D2, which is connected with the bit line, and the channel layer formation carrier region of the memory well W1 directly below the memory gate structure 4a in the memory cell 3a.

Simultaneously, in the memory cell 3a to which no data is to be programmed, for example, a gate off voltage of 0 V is applied from the first select gate line to the first select gate electrode G2a, and a source off voltage of 0 V is applied from the source line to the source region D1. Accordingly, the first select gate structure 5a becomes a non-conductive state (off state) to block the electrical connection between the source region D1, which is connected with the source line, and the channel layer formation carrier region of the memory well W1 directly below the memory gate structure 4a in the memory cell 3a. A substrate voltage of 0 V, which is equal to the charge storage bit voltage, is applied to the memory well W1.

In this case, no carriers exist in the channel layer formation carrier region below the memory gate structure 4a of the memory cell 3a through the carrier removing operation in advance. In this state, the memory well W1 is in a non-conductive state directly below the second select gate structure 6a and the first select gate structure 5a on both sides of the memory gate structure 4a. Accordingly, a depleted layer (not illustrated) in which no charge exists is formed in the memory well W1 directly below the memory gate structure 4a.

As a result, in the memory cell 3a to which no data is to be programmed, voltage decreases through the three layers of the upper gate insulating film 23b, the charge storage layer EC, and the lower gate insulating film 23a, generating a voltage difference between the memory gate electrode G1a and the surface of the memory well W1. Voltage further decreases through the depleted layer extending to a certain depth from the surface of the memory well W1, finally reaching at the substrate voltage of 0 V.

In the present embodiment, when the charge storage gate voltage of 12 V is applied the memory gate electrode G1a of the memory gate structure 4a in the memory cell 3a, the voltage difference between the memory gate electrode G1a and the surface of the memory well W1 is 3.5 V approximately (for example, when a flat band voltage Vfb is 0 V, a memory gate voltage Vg is 12 V, the memory well W1 has an acceptor concentration Na of 2.0E17 cm⁻³, the upper gate insulating film 24b has a thickness of 2 nm, the charge storage layer EC has a thickness of 12 nm, and the lower gate insulating film has a thickness of 2 nm). The voltage difference is not large enough to cause the quantum tunneling effect between the memory gate electrode G1a and the surface of the memory well W1, thereby preventing charge injection into the charge storage layer EC.

In addition, no impurity diffusion region having a high impurity concentration is formed in a region of the memory well W1 between the memory gate structure 4a and the second select gate structure 6a in the memory cell 3a. Thus, a depleted layer can be reliably formed in the memory well W1 between the memory gate structure 4a and the second select gate structure 6a. This depleted layer prevents the potential at the surface of the memory well W1 directly below the memory gate structure 4a from reaching at the gate insulating film 25b, thereby preventing dielectric breakdown of the gate insulating film 25b due to the potential at the surface of the memory well W1.

In addition, no impurity diffusion region having a high impurity concentration is formed in a region of the memory well W1 between the memory gate structure 4a and the first select gate structure 5a. Thus, a depleted layer can be reliably formed in the memory well W1 between the memory gate structure 4a and the first select gate structure 5a. This depleted layer prevents the potential at the surface of the memory well W1 directly below the memory gate structure 4a from reaching at the gate insulating film 25a, thereby preventing dielectric breakdown of the gate insulating film 25a due to the potential at the surface of the memory well W1.

In the carrier removing operation described above, carriers may be removed from the channel layer formation carrier region to form a depleted layer, for example, by blocking, through the first select gate structure 5a, the electrical connection between the channel layer formation carrier region and the source region D1 to send the carriers inside the channel layer formation carrier region only to the drain region D2, or by blocking, through the second select gate structure 6a, the electrical connection between the channel layer formation carrier region and the drain region D2 to send the charges inside the channel layer formation carrier region only to the source region D1.

### (1-3-2) Second programming method

When data is to be programmed to the memory cell 3a, the second programming method is same as "(1-3-1) First programming method" described above except that the carrier removing operation is not performed, and thus description thereof will be omitted. When no charge is to be injected into the charge storage layer EC of the memory cell 3a at application of a high charge storage gate voltage to the memory gate electrode G1a, the charge storage gate voltage of 12 V is applied from the memory gate line to the memory gate electrode G1a. Accordingly, the charge storage gate voltage is applied to the memory well W1 to form a channel layer (not illustrated) along the surface of the memory well W1 facing the memory gate electrode G1a of the memory cell 3a.

For example, a gate off voltage of 0 V is applied from the first select gate line to the first select gate electrode G2a of the first select gate structure 5a of the memory cell 3a, and a source off voltage of 0 V is applied from the source line to the source region D1. Accordingly, the memory well W1 facing the first select gate electrode G2a becomes a non-conductive state to block the electrical connection between the source region D1 connected with the source line and the channel layer below the memory gate structure 4a.

In addition, for example, a second select gate voltage of 1.5 V is applied from the second select gate line to the second select gate electrode G3a of the second select gate structure 6a of the memory cell 3a, and an off voltage of 1.5 V is applied from the bit line to the drain region D2. Accordingly, the memory well W1 facing the second select gate electrode G3a of the second select gate structure 6a becomes a non-conductive state to block the electrical connection between the drain region D2 connected with the bit line and the channel layer below the memory gate structure 4a.

In this case, the memory well W1 is in a non-conductive state below the second select gate structure 6a and the first select gate structure 5a on both sides of the memory gate structure 4a of the memory cell 3a. Accordingly, the electrical connection between the channel layer, which is formed in the surface of the memory well W1 by the memory gate electrode G1a, and each of the drain region D2 and the source region D1 is blocked, so that a depleted layer (not illustrated) is formed around the channel layer.

The three-layered configuration of the upper gate insulating film 23b, the charge storage layer EC, and the lower gate insulating film 23a forms a capacitor (gateinsulator capacitor), and the depleted layer formed in the memory well W1 and enclosing the channel layer forms a capacitor (depletion-layer capacitor). The gateinsulator capacitor and the depletion-layer capacitor are connected in series. For example, when the gateinsulator capacitor has a capacitance three times larger than that of the depletion-layer capacitor, the channel layer has a channel potential of 9 V.

Accordingly, when the charge storage gate voltage of 12 V is applied to the memory gate electrode G1a of the memory gate structure 4a, the voltage difference between the memory gate electrode G1a and the channel layer has a reduced value of 3 V since the channel layer enclosed by the depleted layer in the memory well W1 has a channel potential of 9 V. As a result, the quantum tunneling effect does not occur, and thus charge injection into the charge storage layer EC is prevented.

At execution of the above-described operation in the memory cell 3a, the channel potential at start of the operation potentially varies depending on a charge storage state in the memory cell 3a. Thus, it is more desirable to perform, before the data programming operation, an additional operation to set the channel potential of the memory cell 3a equal to the potential of the bit line or the source line by setting, for example, the potential of the bit line or the source line to 0 V, the potential of the second select gate electrode G3a or the first select gate electrode G2a to 1.5 V, and the potential of the memory gate electrode G1a to 1.5 V. In this case, after the channel potential is thus set, the gate off voltage of 0 V may be set back to the second select gate electrode G3a or the first select gate electrode G2a before the programming operation.

### (2) Method for producing semiconductor integrated circuit devices

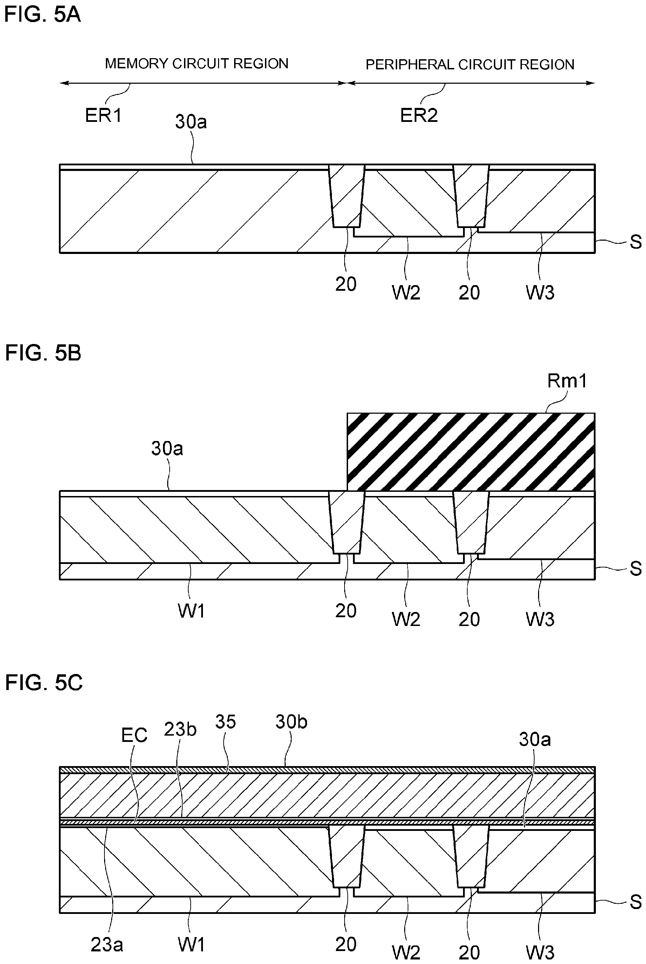

The semiconductor integrated circuit device 1 having the above-described configuration can be produced through a production process described below without an extra dedicated photomask process of electrically separating the first select gate electrode and the second select gate electrode, in addition to a conventional dedicated photomask process of fabricating only the memory circuit region ER1. FIGS. 5A, 5B, and 5C each illustrate a cross section taken along line A-A' in FIG. 1. In this step, first, as illustrated in FIG. 5A, after the semiconductor substrate S is prepared, the element separation layer 20 made of an insulating member is formed at predetermined positions such as boundaries of the memory circuit region ER1 and the peripheral circuit region ER2 by, for example, a shallow trench isolation (STI) method.

A sacrificial oxide film 30a is formed on a surface of the semiconductor substrate S by, for example, a thermal oxidation method to perform impurity implantation. Then, the P-type logic well W2 and the N-type logic well W3 are formed by implanting P-type impurities and N-type impurities into the peripheral circuit region ER2 by, for example, an ion implantation technique.

A resist is patterned by a photolithography technique using a first photomask (not illustrated) dedicated to fabrication of the memory circuit region ER1. As illustrated in FIG. 5B, in which any corresponding part to that in FIG. 5A is denoted by an identical reference numeral, the memory circuit region ER1 is exposed to form a resist Rm1 covering the peripheral circuit region ER2.

The memory well W1 is formed by implanting P-type impurities only into the memory circuit region ER1 through the patterned resist Rm1. In addition, a channel formation layer (not illustrated) is formed on the substrate surface facing the memory gate electrodes G1a and G1b and the sidewall spacer 27a (FIG. 2) to be formed later, by implanting N-type impurities into a surface of the memory circuit region ER1. Then, the resist Rm1 is used to remove the sacrificial oxide film 30a in the memory circuit region ER1 by using, for example, hydrofluoric acid (first photomask fabrication step).

In the first photomask fabrication step, in a case in which a P-type substrate is used as the semiconductor substrate S, the step of forming the memory well W1 by implanting P-type impurities into the semiconductor substrate S may be omitted.

After the resist Rm1 is removed, as illustrated in FIG. 5C, in which any corresponding part to that in FIG. 5B is denoted by an identical reference numeral, an ONO film in which layers of the lower gate insulating film 23a, the charge storage layer EC, and the upper gate insulating film 23b are stacked in this order is formed on the entire surfaces of the memory circuit region ER1 and the peripheral circuit region ER2. Then, a memory gate electrode conductive layer 35 to be formed into the memory gate electrodes G1a and G1b is formed on the upper gate insulating film 23b. Subsequently, a protection insulating layer 30b made of an insulating member is formed on the memory gate electrode conductive layer 35 by, for example, the thermal oxidation method and a chemical vapor deposition (CVD) method.

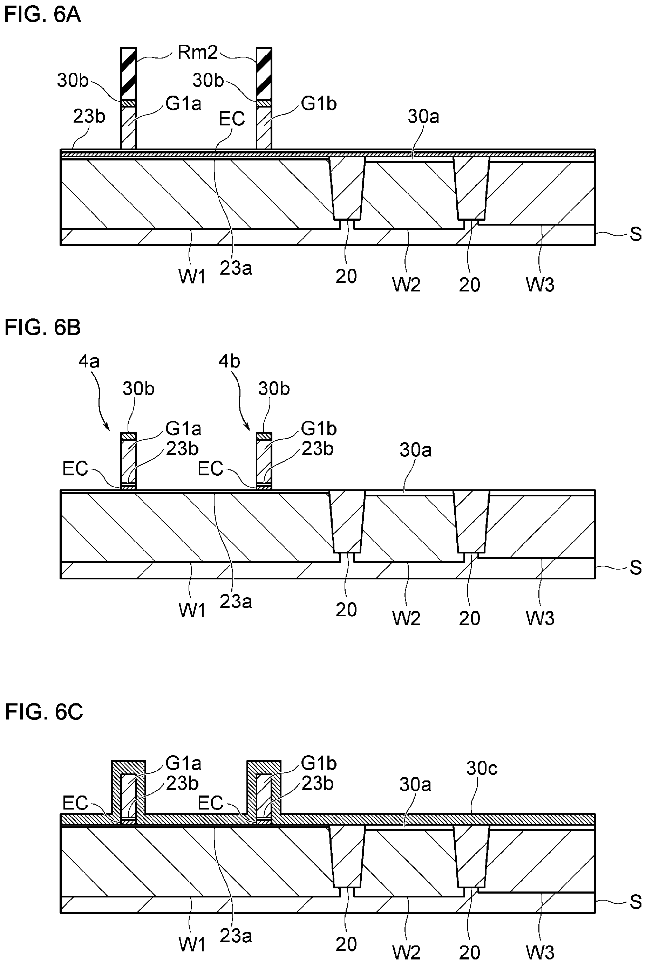

A resist is patterned by the photolithography technique using a second photomask (not illustrated) dedicated to fabrication of the memory circuit region ER1. As illustrated in FIG. 6A, in which any corresponding part to that in FIG. 5C is denoted by an identical reference numeral, a resist Rm2 is formed only where the memory gate structures 4a and 4b are to be formed are to be formed. Then, the memory gate electrode conductive layer 35 is patterned through the resist Rm2 to form the memory gate electrodes G1a and G1b (second photomask fabrication step).

After the resist Rm2 is removed, the upper gate insulating film 23b and the charge storage layer EC exposed where the memory gate electrodes G1a and G1b are not formed are removed (ON film is removed) in this order as illustrated in FIG. 6B, in which any corresponding part to that in FIG. 6A is denoted by an identical reference numeral. Accordingly, the upper gate insulating film 23b and the charge storage layer EC are similarly patterned below the patterned memory gate electrodes G1a and G1b.As a result, lower gate insulating film 23a, the charge storage layer EC, the upper gate insulating film 23b, and the memory gate electrode G1a (G1b) are stacked in this order to form the memory gate structure 4a (4b) in the memory circuit region ER1 (memory gate structure formation step).

A protection insulating film 30c is formed on the entire surfaces of the memory circuit region ER1 and the peripheral circuit region ER2 as illustrated in FIG. 6C, in which any corresponding part to that in FIG. 6B is denoted by an identical reference numeral. The present embodiment describes a case in which the single-layer protection insulating film 30c is formed on the entire surfaces, but the present invention is not limited to a single-layer film. For example, a two-layer protection insulating film in which an insulating oxide film and an insulating nitride film are stacked in this order may be formed on the entire surfaces.

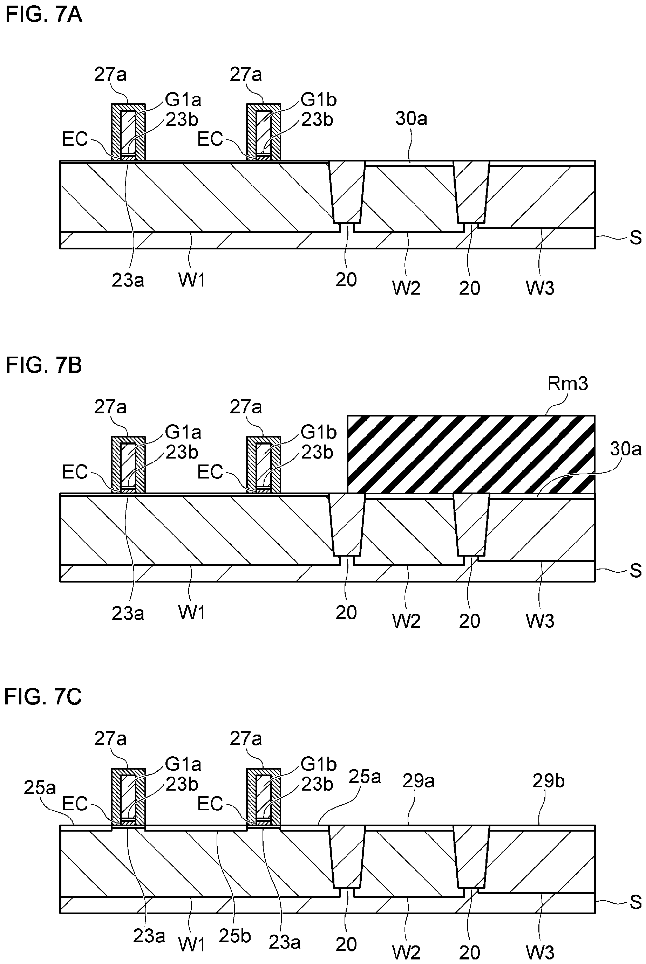

As illustrated in FIG. 7A, in which any corresponding part to that in FIG. 6C is denoted by an identical reference numeral, the protection insulating film 30c is etched back to form the sidewall spacer 27a covering around the memory gate structures 4a and 4b (sidewall spacer formation step). Subsequently, a resist is patterned by the photolithography technique using a third photomask (not illustrated) dedicated to fabrication of the memory circuit region ER1. This patterning forms a resist Rm3 covering the entire surface of the peripheral circuit region ER2 but leaving the memory circuit region ER1 exposed, as illustrated in FIG. 7B, in which any corresponding part to that in FIG. 7A is denoted by an identical reference numeral.

Impurities are implanted through the resist Rm3 to the memory circuit region ER1, where the first select gate structures 5a and 5b (FIG. 2) and the second select gate structures 6a and 6b (FIG. 2) are to be formed. This impurity implantation forms a channel formation layer (not illustrated) in regions of the substrate surface facing the second select gate electrodes G3a and G3b and the first select gate electrode G2a and G2b to be formed later (third photomask fabrication step).

After the resist Rm3 is removed, the sacrificial oxide film 30a in the peripheral circuit region ER2 is removed by using, for example, hydrofluoric acid. Then, as illustrated in FIG. 7C, in which any corresponding part to that in FIG. 7B is denoted by an identical reference numeral, for example, the thermal oxidation method is employed to form the gate insulating films 25a and 25b where the first select gate electrode G2a and G2b (FIG. 1) and the second select gate electrodes G3a and G3b are to be formed in the memory circuit region ER1. The thermal oxidation method is also employed to form the gate insulating films 29a and 29b where the logic gate electrodes G5 and G6 (FIG. 1) are to be formed in the peripheral circuit region ER2.

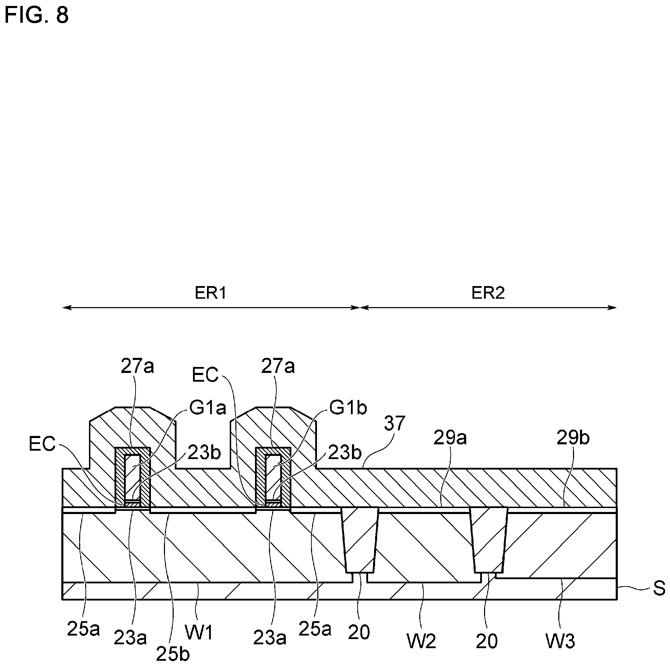

As illustrated in FIG. 8, in which any corresponding part to that in FIG. 7C is denoted by an identical reference sign, a conductive layer 37 that is to be the first select gate electrodes G2a and G2b, the second select gate electrodes G3a and G3b, and the logic gate electrodes G5 and G6 through later fabrication is formed on the entire surfaces of the memory circuit region ER1 and the peripheral circuit region ER2 (conductive layer formation step).

The conductive layer 37 in the memory circuit region ER1 and the peripheral circuit region ER2 is patterned by using a resist (to be described later) patterned through a photomask (not illustrated) by a photolithography technique.

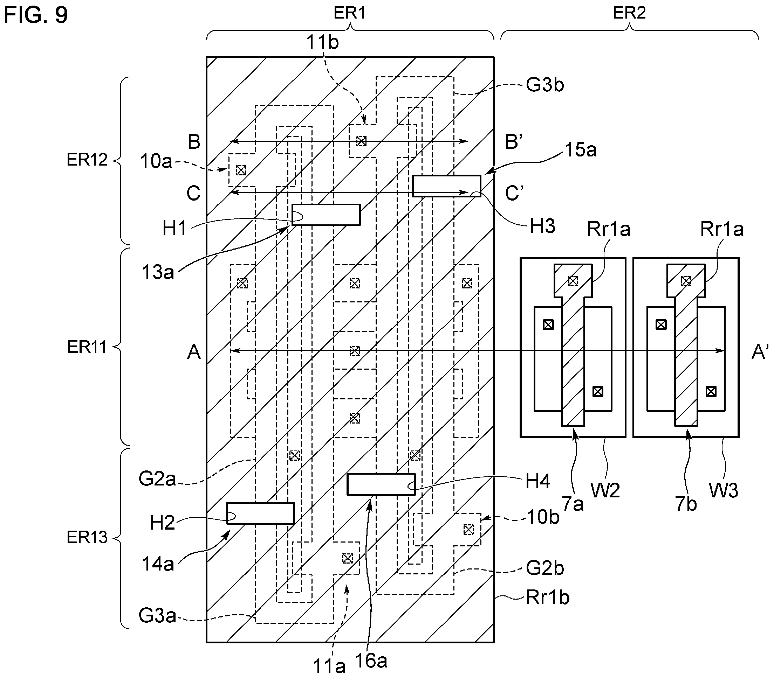

FIG. 9 is a schematic view illustrating a state in which resists Rr1a and Rr1b formed through the above-described step are placed over the planar layout of the completed semiconductor integrated circuit device 1 illustrated in FIG. 1. In the present embodiment, as illustrated in FIG. 9, the resist Rr1a is disposed where the logic gate structures 7a and 7b are to be formed in the peripheral circuit region ER2. The resist Rr1a is patterned in accordance with the outline shapes of the logic gate structures 7a and 7b to be formed later. Openings H1, H2, H3, and H4 are provided in the memory circuit region ER1 so that regions (hereinafter referred to as select gate electrode cutout planned regions) 13a, 14a, 15a, and 16a to be formed later in which the select gate electrode cutout portions 13, 14, 15, and 16 are to be formed are externally exposed through the openings H1, H2, H3, and H4. The resist Rr1b covers all the other region except the select gate electrode cutout planned regions 13a, 14a, 15a, and 16a.

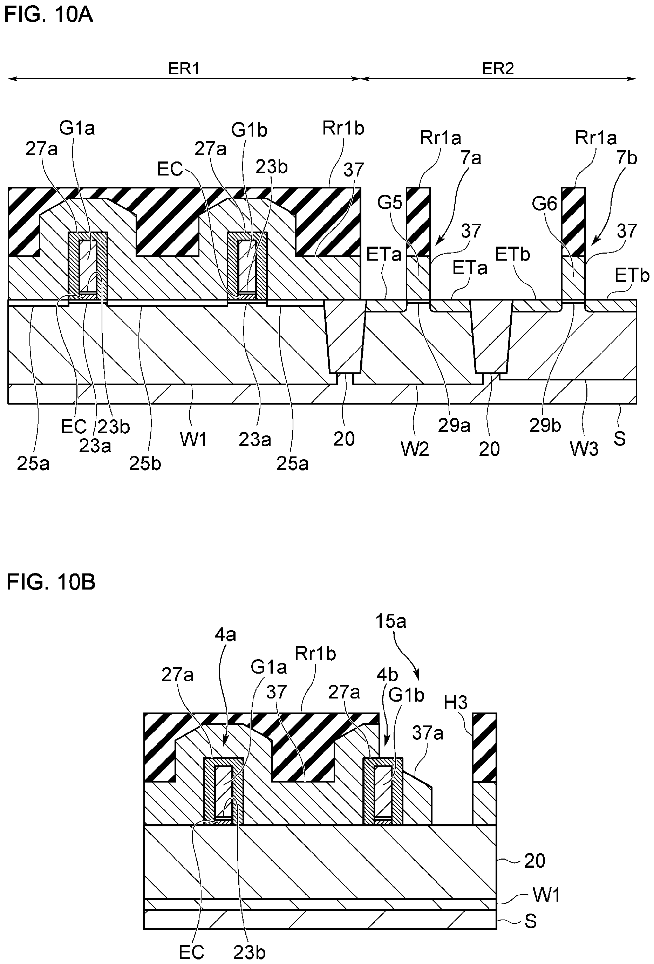

Then, the conductive layer 37 in the memory circuit region ER1 and the peripheral circuit region ER2 is patterned by using the resists Rr1a and Rr1b. Accordingly, as illustrated in FIG. 10A, in which any corresponding part to that in FIG. 8 is denoted by an identical reference sign, in the peripheral circuit region ER2, the conductive layer 37 being externally exposed is removed, whereas only the conductive layer 37 and the gate insulating films 29a and 29b being covered by the resist Rr1a remain. As a result, in the peripheral circuit region ER2, the logic gate electrodes G5 and G6 are formed in accordance with the outline shape of the resist Rr1a, and the logic gate structures 7a and 7b in which the logic gate electrodes G5 and G6 are stacked on the gate insulating films 29a and 29b, respectively, are formed (a logic gate structure formation step).

In addition at the logic gate structure formation step, part of the conductive layer 37 being exposed through the openings H1, H2, H3, and H4 of the resist Rr1b formed in the select gate electrode cutout planned regions 13a, 14a, 15a, and 16a is removed in the memory circuit region ER1 as illustrated in FIG. 9. FIG. 10B is a schematic view illustrating a cross section taken along line C-C' in FIG. 9 at the logic gate structure formation step. As illustrated in FIG. 10B, the conductive layer 37 being exposed is removed through the opening H3 of the resist Rr1b formed in the select gate electrode cutout planned region 15a at the logic gate structure formation step. As a result, the conductive layer 37 remains in a sidewall shape along a sidewall of the sidewall spacer 27a covering the memory gate structure 4b, forming a sidewall-shaped remaining conductive layer 37a on the element separation layer 20. Simultaneously, in the opening H3 of the resist Rrlb, the conductive layer 37 at a part other than the remaining conductive layer 37a is all removed to externally expose the element separation layer 20.

In each of the select gate electrode cutout planned regions 13a, 14a, and 16a other than the select gate electrode cutout planned region 15a, the conductive layer 37 remains in a sidewall shape along the sidewall of the sidewall spacer 27a covering the memory gate structure 4b at the logic gate structure formation step. Accordingly, the sidewall-shaped remaining conductive layer 37a is formed on the element separation layer 20, and whereas the conductive layer 37 at a part other than the remaining conductive layer 37a is all removed.

Then, after the resists Rr1a and Rr1b are removed by, for example, ashing, a resist patterned for an N-type or a P-type is used to implant low concentration of N-type impurities or P-type impurities into the peripheral circuit region ER2 by, for example, the ion implantation technique. Accordingly, as illustrated in FIG. 10A (FIG. 10A illustrates the resists Rr1a and Rr1b, which are otherwise removed in this step), an N-type extension region ETa is formed on the substrate surface in the logic well W2 being externally exposed, whereas a P-type extension region ETb is formed on the substrate surface in the logic well W3 being externally exposed.

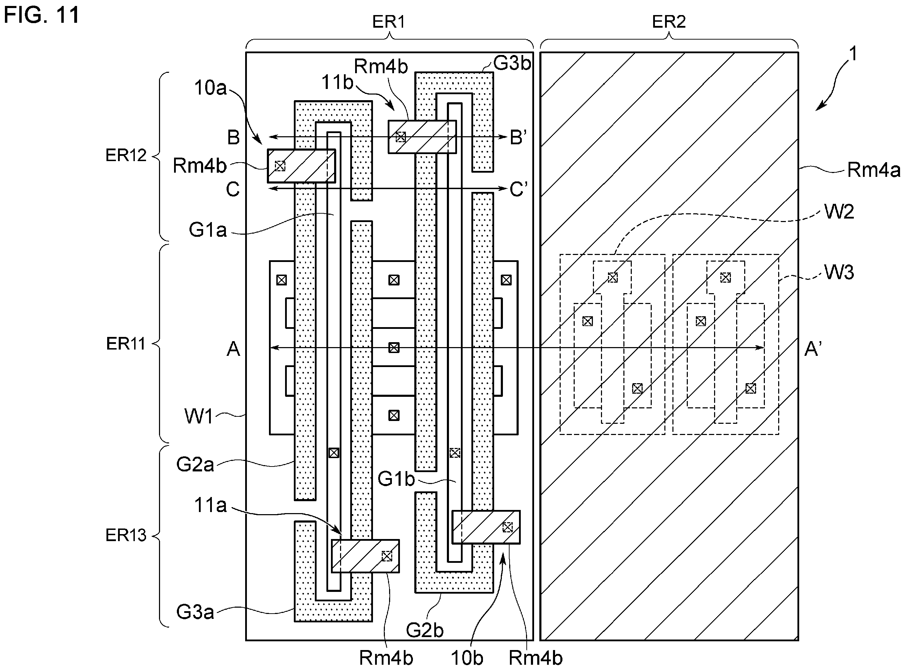

Subsequently, a resist is patterned by the photolithography technique using a fourth photomask (not illustrated) for a contact formation conductive layer, which is dedicated to fabrication of the memory circuit region ER1. This resist is used to fabricate only the conductive layer 37 in the memory circuit region ER1. FIG. 11 is a schematic view illustrating a state in which resists Rm4a and Rm4b patterned through the fourth photomask are placed over the planar layout of the completed semiconductor integrated circuit device 1 illustrated in FIG. 1.

As illustrated in FIG. 11, the resists Rm4a and Rm4b are dedicated to fabrication of the memory circuit region ER1. Thus, the resist Rm4a covers the entire surface of the peripheral circuit region ER2, whereas the resist Rm4b covers only where the contact formation conductive layers 10a, 11a, 10b, and 11b are to be formed in the gate-contact and cutout regions ER12 and ER13 of the memory circuit region ER1.

Then, the conductive layer 37 (FIG. 8) being exposed in the memory circuit region ER1 is etched back while the resist Rm4a covers the entire surface of the peripheral circuit region ER2 and the resist Rm4b covers where the contact formation conductive layers 10a, 11a, 10b, and 11b are to be formed in the gate-contact and cutout regions ER12 and ER13 of the memory circuit region ER1 (a conductive layer patterning step).

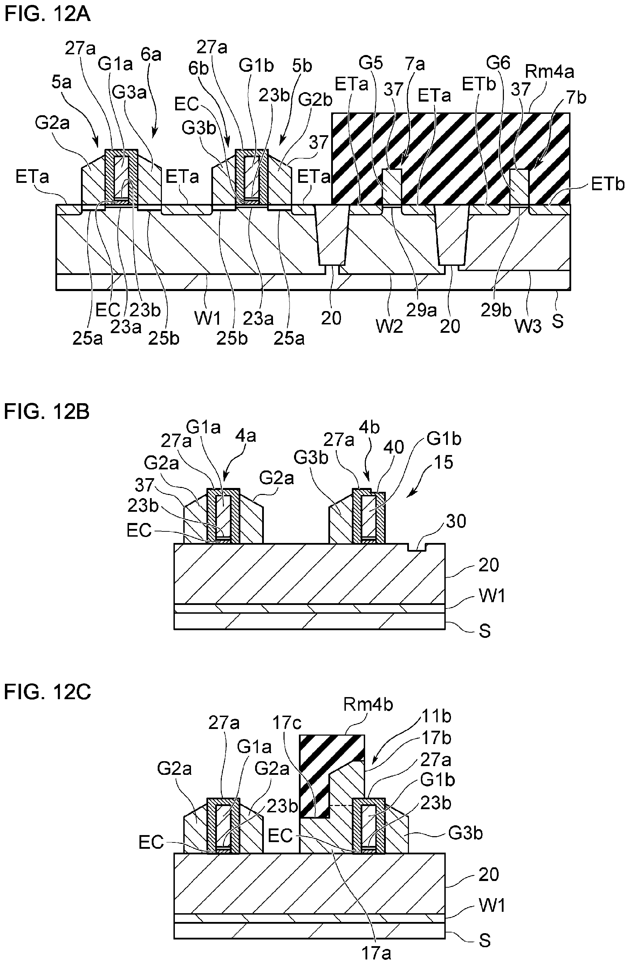

Accordingly, as illustrated in FIG. 12A, in which any corresponding part to that in FIG. 10A is denoted by an identical reference sign, the logic gate electrodes G5 and G6 being covered by the resist Rm4a remain intact in the peripheral circuit region ER2. The conductive layer 37 being exposed is etched back in the memory circuit region ER1, and thus the conductive layer 37 remains in a sidewall shape along the sidewall spacer 27a on the sidewalls of the memory gate electrodes G1a and G1b. Accordingly, in the memory circuit region ER1, the sidewall-shaped first select gate electrode G2a (G2b) and second select gate electrode G3a (G3b) are formed along the sidewall spacer 27a on the sidewall of the memory gate electrode G1a (G1b) to form the first select gate structure 5a (5b) in which the first select gate electrode G2a (G2b) is disposed on the patterned gate insulating film 25a, and the second select gate structure 6a (6b) in which the second select gate electrode G3a (G3b) is disposed on the patterned gate insulating film 25b.

For example, in the select gate electrode cutout planned region 15a (FIG. 10B), since part of the conductive layer 37 is removed in advance through the logic gate structure formation step to form the remaining conductive layer 37a having a sidewall shape along the sidewall of the sidewall spacer 27a covering the memory gate structure 4b, the etching back of the conductive layer 37 being exposed in the memory circuit region ER1 through the conductive layer patterning step completely removes the remaining conductive layer 37a (FIG. 10B) as illustrated in FIG. 12B, in which any corresponding part to that in FIG. 10B is denoted by an identical reference sign, thereby forming the select gate electrode cutout portion 15 in the gate-contact and cutout region ER12. Similarly, in the other select gate electrode cutout planned regions 13a, 14a, and 16a, the sidewall-shaped remaining conductive layer 37a formed along the sidewall of the sidewall spacer 27a covering the memory gate structure 4b is completely removed to form the select gate electrode cutout portions 13, 14, and 16 in the gate-contact and cutout regions ER12 and ER13.

Accordingly, in the memory circuit region ER1, the first select gate electrode G2a (G2b) and the second select gate electrode G3a (G3b) are electrically separated from each other through the select gate electrode cutout portion 13 (15) formed in the gate-contact and cutout region ER12, and the first select gate electrode G2a (G2b) and the second select gate electrode G3a (G3b) are electrically separated from each other through the select gate electrode cutout portion 14 (16) formed in the gate-contact and cutout region ER13.

In this manner, in the memory circuit region ER1, when the first select gate electrode G2a (G2b) and the second select gate electrode G3a (G3b) are formed by etching back the conductive layer 37 through the conductive layer patterning step, the remaining conductive layer 37a remaining in each of the select gate electrode cutout planned regions 13a and 14a (15a and 16a) is removed to form the select gate electrode cutout portions 13 and 14 (15 and 16) that electrically separate the first select gate electrode G2a (G2b) and the second select gate electrode G3a (G3b) from each other.

Along line C-C' in the gate-contact and cutout region ER12 illustrated in FIG. 11, when the conductive layer 37 being exposed in the memory circuit region ER1 is etched back through the conductive layer patterning step, the conductive layer 37 remains in a sidewall shape along the sidewall of the sidewall spacer 27a covering the memory gate structure 4a, thereby forming the sidewall-shaped first select gate electrodes G2a facing each other through the memory gate electrode G1a and the sidewall spacer 27a as illustrated in FIG. 12B.

Simultaneously, part of the sidewall spacer 27a and the element separation layer 20 being externally exposed through the opening H3 of the resist Rr1b in the logic gate structure formation step as illustrated in FIG. 10B is removed through the conductive layer patterning step, leaving a chipped portion 40 near a top portion of the sidewall spacer 27a as illustrated in FIG. 12B. In addition, part of the surface of the element separation layer 20 is removed, leaving the recess 30 in the element separation layer 20.

In addition, through the conductive layer patterning step, the conductive layer 37 around part of the memory gate electrode G1a (G1b) in the memory circuit region ER1 remains intact through the resist Rm4b (FIG. 11) disposed in the memory circuit region ER1, forming the contact formation conductive layers 10a and 11a (10b and 11b) on the first select gate electrode G2a (G2b) and the second select gate electrode G3a (G3b) in the memory circuit region ER1 as illustrated in FIG. 1.

In this case, the contact formation conductive layer 10a (10b) is provided continuously with the first select gate electrode G2a (G2b), and the contact formation conductive layer 11a (11b) is provided continuously with the second select gate electrode G3a (G3b). The contact formation conductive layers 10a, 11a, 10b, and 11b all have identical configurations, and thus the following description will be made mainly on the contact formation conductive layer 11b disposed along line B-B' in FIG. 11.

FIG. 12C is a schematic view illustrating a cross section taken along line B-B' in FIG. 11 at the conductive layer patterning step. As illustrated in FIG. 12C, the base 17a disposed on the element separation layer 20 and the mounting portion 17b on part of the top portion of the memory gate electrode G1b are integrated in the contact formation conductive layer 11b. The contact installation surface 17c, which is shaped flat in accordance with the surface shape of the element separation layer 20, is formed on the base 17a.

In the conductive layer patterning step as described above, the conductive layer 37 in the memory circuit region ER1 is fabricated to form the first select gate electrode G2a (G2b) and the second select gate electrode G3a (G3b) electrically separated from each other through the select gate electrode cutout portions 13 and 14 (15 and 16) in the memory circuit region ER1. Simultaneously, the contact formation conductive layers 10a and 11a (10b and 11b) are formed on the first select gate electrode G2a (G2b) and the second select gate electrode G3a (G3b).

In the present embodiment, the etching back of the conductive layer 37 in the conductive layer patterning step is performed by anisotropic etching to form the first select gate electrodes G2a and G2b and the second select gate electrodes G3a and G3b having sidewall shapes along the sidewall spacers 27a on the sidewalls of the memory gate structures 4a and 4b.

However, the present invention is not limited thereto. In the conductive layer patterning step, the etching back of the conductive layer 37 by isotropic etching may be additionally performed after the etching back of the conductive layer 37 by anisotropic etching. The remaining conductive layer 37a at the select gate electrode cutout portions 13, 14, 15, and 16 can be completely removed through this conductive layer patterning step involving different kinds of etching of anisotropic etching and isotropic etching, thereby more reliably achieving cutout between the first select gate electrode G2a (G2b) and the second select gate electrode G3a (G3b).

In particular, since the etching back of the conductive layer 37 in the conductive layer patterning step according to the present invention is performed while the peripheral circuit region ER2 is being covered by the resist Rm4a, the additional isotropic etching does not change the dimensions of the logic gate electrodes G5 and G6 formed through the previous logic gate structure formation step nor increase fluctuation of the dimensions. Thus, cutout at the select gate electrode cutout portions 13, 14, 15, and 16 can be more reliably achieved while the logic gate electrodes G5 and G6 having desired dimensions are maintained intact.

In addition, the additional etching back of the conductive layer 37 by isotropic etching after the etching back of the conductive layer 37 by anisotropic etching can achieve more reliable cutout at the select gate electrode cutout portions 13, 14, 15, and 16, in particular, when a two-layer protection insulating film in which an insulating oxide film and an insulating nitride film are stacked in this order is employed as the protection insulating film 30c in an embodiment.

When the two-layer protection insulating film in which the insulating oxide film and the insulating nitride film are stacked in this order is employed as the protection insulating film 30c, too, the sidewall spacer 27a is formed on the sidewall of the memory gate structure 4a through the sidewall spacer formation step. However, when a sidewall spacer made of two layers of an insulating oxide film and an insulating nitride film is etched back, the insulating oxide film is more largely etched than the insulating nitride film. Thus, the insulating oxide film below the insulating nitride film formed in a sidewall shape is slightly removed, and accordingly has a recessed sectional shape with the insulating nitride film serving as a cover in some cases.

In such a case, through the following conductive layer formation step, the conductive layer 37 enters into a recessed region of the insulating oxide film disposed below the insulating nitride film. Thus, when the remaining conductive layer 37a inside the select gate electrode cutout planned regions 13a and 14a (15a and 16a) is removed, part of the remaining conductive layer having entered into the recessed region of the insulating oxide film is not removed through the etching back by anisotropic etching due to the insulating nitride film serving as a cover, which results in insufficient formation of the select gate electrode cutout portions 13 and 14 (15 and 16) that electrically separate the first select gate electrode G2a (G2b) and the second select gate electrode G3a (G3b) from each other.

In another embodiment in which the etching back of the conductive layer 37 by isotropic etching is additionally performed, however, the part of the remaining conductive layer having entered into the recessed region of the insulating oxide film can be removed, thereby reliably forming the select gate electrode cutout portions 13 and 14 (15 and 16) that electrically separate the first select gate electrode G2a (G2b) and the second select gate electrode G3a (G3b).

Thereafter, low concentration of N-type impurities are implanted into the memory circuit region ER1 not being covered by the resist Rm4b by, for example, the ion implantation technique to form the extension region ETa on the surface of the memory well W1 being externally exposed in the memory circuit region ER1 as illustrated in FIG. 12A.

Lastly, the resists Rm4a and Rm4b are removed, followed by a step of forming the sidewall structure SW, a step of forming the source regions D1 and D3 and the drain regions D2 by implanting high concentration of N-type impurities or P-type impurities into necessary places by, for example, the ion implantation technique, a step of forming the silicide SC, and a step of forming, for example, the insulating layer 21 and the contacts C1, C2, C3, .... The semiconductor integrated circuit device 1 having the configuration illustrated in FIGS. 1, 2, 3, and 4 is produced by sequentially performing these steps.

### (3) Operations and effects

In the method for producing the semiconductor integrated circuit device 1 as described above, when the conductive layer 37 in the peripheral circuit region ER2 is patterned by using the patterned resists Rr1a and Rr1b to form the logic gate electrodes G5 and G6 on the gate insulating films 29a and 29b, the resists Rr1a and Rr1b are also used to remove part of the conductive layer 37 in the select gate electrode cutout planned regions 13a, 14b, 15a, and 16a in the memory circuit region ER1 (FIGS. 9 to 10).

In addition, in this photomask process of forming the logic gate electrodes G5 and G6 in the peripheral circuit region ER2 in the production method, part of the conductive layer 37 in the select gate electrode cutout planned regions 13a, 14a, 15a, and 16a in the memory circuit region ER1 is removed in advance. In this state, the conductive layer 37 in the memory circuit region ER1 is etched back by using the resists Rm4a and Rm4b patterned to cover the entire surface of the peripheral circuit region ER2 and cover where the contact formation conductive layers 10a, 11a, 10b, and 11b are to be formed in the memory circuit region ER1 (FIGS. 11 and 12).

Accordingly, in the production method, the sidewall-shaped first select gate electrode G2a (G2b) and the sidewall-shaped second select gate electrode G3a (G3b) are formed around the sidewall spacer 27a of the memory gate structure 4a (4b). In addition, when the first select gate electrode G2a (G2b) and the second select gate electrode G3a (G3b) are formed, the remaining conductive layer 37a in the select gate electrode cutout planned regions 13a and 14a (15a and 16a) can be entirely removed to form the select gate electrode cutout portions 13 and 14 (15 and 16) that electrically separate the first select gate electrode G2a (G2b) and the second select gate electrode G3a (G3b) from each other (FIG. 1).

Thus, when the first select gate electrode G2a (G2b) and the second select gate electrode G3a (G3b) that are independently controllable are formed in the production process according to the present invention, an extra dedicated photomask process for electrically separating the first select gate electrode G2a (G2b) and the second select gate electrode G3a (G3b) is not needed in addition to a conventional dedicated photomask process of fabricating a memory circuit region only, thereby achieving reduction in a production cost accordingly.

In addition, in the production method, when the first select gate electrode G2a (G2b) and the second select gate electrode G3a (G3b) electrically separated from each other through the select gate electrode cutout portions 13 and 14 (15 and 16) are formed, the conductive layer 37 remains intact at predetermined positions in the memory circuit region ER1 through the resist Rm4b to form the contact formation conductive layers 10a and 11a (10b and 11b) provided continuously with the first select gate electrode G2a (G2b) and the second select gate electrode G3a (G3b), simultaneously with the first select gate electrode G2a (G2b), the second select gate electrode G3a (G3b), and the select gate electrode cutout portions 13 and 14 (15 and 16).

In this method for producing the semiconductor integrated circuit device 1, a dedicated photomask process of patterning a resist through a photomask dedicated to fabrication of the memory circuit region ER1 only involves a total of four steps of the first photomask fabrication step (FIG. 5B) of forming, by impurity implantation, a channel formation layer where the memory gate structures 4a and 4b are to be formed on the substrate surface and removing the sacrificial oxide film 30a in the memory circuit region ER1; the second photomask fabrication step (FIG. 6A) of patterning the memory gate electrode conductive layer 35 to form the memory gate electrodes G1a and G1b; the third photomask fabrication step (FIG. 7B) of forming, by impurity implantation, a channel formation layer where the first select gate electrodes G2a and G2b and the second select gate electrodes G3a and G3b are to be formed; and the fourth photomask fabrication step (FIGS. 12A to 12C) of forming the first select gate electrodes G2a and G2b, the second select gate electrodes G3a and G3b, the select gate electrode cutout portions 13, 14, 15, and 16, and the contact formation conductive layers 10a, 11a, 10b, and 11b in the memory circuit region ER1.

Accordingly, in the method of producing the semiconductor integrated circuit device 1, an extra process of producing four photomasks in addition to a typical process of producing a peripheral circuit allows incorporation of the memory cells 3a, 3c, 3e, 3b, 3d, and 3f for which the first select gate electrode G2a (G2b) and the second select gate electrode G3a (G3b) disposed with the memory gate electrode G1a (G1b) interposed therebetween are independently controllable, thereby achieving cost reduction.

Unlike a production method (hereinafter simply referred to as a conventional production method) disclosed in International Patent Application Publication No. WO2016/060012A1 by the inventors of the present application, the method for producing the semiconductor integrated circuit device 1 of the present invention forms the logic gate electrodes G5 and G6 in the peripheral circuit region ER2 before the first select gate electrodes G2a and G2b and the second select gate electrodes G3a and G3b in the memory circuit region ER1. According to the present invention, the conductive layer 37 can be etched back while the peripheral circuit region ER2 is being covered by the resist Rm4a through the conductive layer patterning step in the above-described production process. This configuration can prevent change in the dimensions of the logic gate electrodes G5 and G6 already formed in the peripheral circuit region ER2 through the previous logic gate structure formation step and increases in fluctuation of the dimensions when the amount of etching back is adjusted or etching isotropic is additionally performed. Accordingly, in the method for producing the semiconductor integrated circuit device 1 of the present invention, the select gate electrode cutout portions 13, 14, 15, and 16 can be reliably formed by removing all the remaining insulating film 37a inside the select gate electrode cutout planned regions 13a and 14a (15a and 16a) while the logic gate electrodes G5 and G6 having desired dimensions are maintained intact, which is an advantageous effect that cannot be achieved by the conventional production method.

In order to prevent, by the first programming method, charge injection into the charge storage layer EC when a charge storage gate voltage enough to allow the charge injection is applied to the memory gate electrode G1a of the memory cell 3a, carriers induced in the channel layer formation carrier region of the memory well W1 facing the memory gate electrode G1a are removed from the channel layer formation carrier region, and then the second select gate structure 6a blocks the electrical connection between the region of the memory well W1 facing the memory gate electrode G1a and the drain region D2, and the first select gate structure 5a blocks the electrical connection between the region of the memory well W1 facing the memory gate electrode G1a and the source region D1.

With this configuration, a depleted layer is formed in the channel layer formation carrier region without a channel layer in the memory cell 3a. As a result, the potential at the surface of the memory well W1 increases in accordance with the charge storage gate voltage, and the voltage difference between the memory gate electrode G1a and the surface of the memory well W1 decreases accordingly. In this manner, the charge injection into the charge storage layer EC is prevented, and the depleted layer prevents the potential at the surface of the memory well W1 directly below the memory gate structure 4a from reaching at the gate insulating film 25b and the gate insulating film 25a.

Thus, voltage applied to the bit line and the source line in the memory cell 3a is not restricted by a high charge storage gate voltage necessary for injecting charge into the charge storage layer EC by the quantum tunneling effect, but can be reduced to voltage necessary for the second select gate structure 6a to block the electrical connection between the bit line and the region of the memory well W1 facing the memory gate electrode G1a, or to voltage necessary for the first select gate structure 5a to block the electrical connection between the source line and the region of the memory well W1 facing the memory gate electrode G1a. Thus, the thicknesses of the gate insulating film 25b of the second select gate structure 6a and the gate insulating film 25a of the first select gate structure 5a in the memory cell 3a can be reduced in accordance with the reduction of voltage applied to the bit line and the source line. This thickness reduction leads to a faster operation.

In the memory cell 3a, in order to prevent, by the second programming method, charge injection into the charge storage layer EC when a charge storage gate voltage enough to allow the charge injection is applied to the memory gate electrode G1a to form a channel layer in the surface of the memory well W1 facing the memory gate electrode G1a, the second select gate structure 6a blocks the electrical connection between the drain region D2 and the channel layer, and the first select gate structure 5a blocks the electrical connection between the source region D1 and the channel layer.

With this configuration, a depleted layer is formed around the channel layer in the memory well W1 facing the memory gate structure 4a in the memory cell 3a. As a result, the channel potential of the channel layer increases in accordance with the charge storage gate voltage, and the voltage difference between the memory gate electrode G1a and the channel layer decreases accordingly. In this manner, the charge injection into the charge storage layer EC is prevented, and the depleted layer blocks voltage application from the channel layer to the gate insulating film 25b and the gate insulating film 25a.

Thus, voltage applied to the bit line and the source line in the memory cell 3a is not restricted to a high charge storage gate voltage necessary for injecting charge into the charge storage layer EC by the quantum tunneling effect, but can be reduced to voltage value necessary for the second select gate structure 6a and the first select gate structure 5a to block the electrical connection between the bit line and the channel layer and the electrical connection between the source line and the channel layer. Thus, the thicknesses of the gate insulating film 25b of the second select gate structure 6a and the gate insulating film 25a of the first select gate structure 5a in the memory cell 3a can be reduced in accordance with the reduction of voltage applied to the bit line and the source line. This thickness reduction leads to a faster operation.

### (4) Production methods according to other embodiments without third photomask fabrication step

In the above-described embodiment, the dedicated photomask process of patterning a resist through a photomask dedicated to fabrication of the memory circuit region ER1 involves a total of four steps of the first photomask fabrication step, the second photomask fabrication step, the third photomask fabrication step, and the fourth photomask fabrication step for a contact formation conductive layer. However, the present invention is not limited thereto. The dedicated photomask process may involve a total of three steps of the first photomask fabrication step, the second photomask fabrication step, and a contact formation conductive layer photomask fabrication step (corresponding to the above-described fourth photomask fabrication step) without the impurity implantation in the third photomask fabrication step.

In other words, the third photomask fabrication step does not need to be performed in a case in which the first select gate structures 5a and 5b and second select gate structures 6a and 6b each has a desired threshold voltage (Vth) without the impurity implantation in the third photomask fabrication step. In that case, the dedicated photomask process can omit the third photomask fabrication step.

In such a production method without the third photomask fabrication step, the sidewall spacer 27a covering around the memory gate structures 4a and 4b is formed as illustrated in FIG. 7A (sidewall spacer formation step). Then, the sacrificial oxide film 30a in the peripheral circuit region ER2 is removed by, for example, hydrofluoric acid. Thereafter, as illustrated in FIG. 7C, for example, the thermal oxidation method is employed to form the gate insulating films 25a and 25b where the first select gate electrodes G2a and G2b (FIG. 1) and the second select gate electrodes G3a and G3b (FIG. 1) are to be formed in the memory circuit region ER1. The thermal oxidation method is also employed to form the gate insulating films 29a and 29b where the logic gate electrodes G5 and G6 are to be formed in the peripheral circuit region ER2 (FIG. 1). Then, similarly to the production method of the above-described embodiment, the semiconductor integrated circuit device 1 illustrated in FIG. 1 is produced through the production steps illustrated in FIGS. 8 to 12.

In another embodiment without the third photomask fabrication step, the memory cells 3a, 3b, 3c, 3d, 3e, and 3f can be incorporated through a production process on three photomasks in addition to a typical peripheral-circuit production process. In the memory cells 3a, 3b, 3c, 3d, 3e, and 3f, the first select gate electrodes G2a and G2b and the second select gate electrodes G3a and G3b are formed to sandwich the memory gate electrodes G1a and G1b, and can be independently controlled. Thus, the production method without the third photomask fabrication step uses a reduced number of photomasks as compared to the production method of the above-described embodiment, which leads to cost reduction.

### (5) Other embodiments

The present invention is not limited to the present embodiment, but various modifications are possible within the scope of the present invention. For example, the number of the memory cells 3a, 3b, 3c, 3d, 3e, and 3f, the number of the peripheral circuits 18 and 19, the number of the contact formation conductive layers 10a, 11a, 10b, and 11b, and the number of the select gate electrode cutout portions 13, 14, 15, and 16 may be any other numbers. The conduction types of the memory well W1, and the logic wells W2 and W3 may be of any one of the N type or the P type.

In the above-described embodiment, for example, the contact formation conductive layers 10a and 11a of the first column and the select gate electrode cutout portions 13 and 14 may be disposed at any positions to allow the first select gate electrode G2a continuous with the contact formation conductive layer 10a and the second select gate electrode G3a continuous with the contact formation conductive layer 11a to be electrically separated from each other to achieve independent control of the first select gate electrode G2a and the second select gate electrode G3a. For example, among four corners of a virtual rectangular surrounding line around the memory gate electrode G1a (G1b), the select gate electrode cutout portion 13 (15) may be disposed at one corner in the gate-contact and cutout region ER12, and the select gate electrode cutout portion 14 (16) may be disposed at one corner in the gate-contact and cutout region ER13. In this case, the end of the first select gate electrode G2a (G2b) and the end of the second select gate electrode G3a (G3b) are not disposed on an identical straight line, but orthogonally disposed at a predetermined distance therebetween.

For example, in the memory circuit region ER1 of the semiconductor integrated circuit device 1 illustrated in FIG. 1, the single contact formation conductive layer 10a and the single select gate electrode cutout portion 13 are provided in the gate-contact and cutout region ER12, and the single contact formation conductive layer 11a and the single select gate electrode cutout portion 14 are provided in the gate-contact and cutout region ER13. However, the present invention is not limited thereto. The two contact formation conductive layers 10a and 11a may be provided in the gate-contact and cutout region ER12, the single select gate electrode cutout portion 13 may be disposed between the two contact formation conductive layers 10a and 11a, and the single select gate electrode cutout portion 14 may be provided in the gate-contact and cutout region ER13.

With this configuration, too, the first select gate electrode G2a continuous with the contact formation conductive layer 10a and the second select gate electrode G3a continuous with the contact formation conductive layer 11a are electrically separated from each other to allow independent control of the first select gate electrode G2a and the second select gate electrode G3a.

In other words, in the method for producing semiconductor integrated circuit devices of the present invention, the select gate electrode cutout portions 13, 14, ... may be disposed where select gate electrodes provided continuously with the contact formation conductive layers 10a, 11a, ... are electrically separated from each other.

In the above-described embodiment, the peripheral circuits 18 and 19 may be other various peripheral circuits (direct peripheral circuits) such as a sense amplifier, a column decoder, and a row decoder disposed in the same area as that of the memory cells 3a, 3b, 3c, 3d, 3e, and 3f. Alternatively, the peripheral circuits 18 and 19 may be other various peripheral circuits, such as a CPU, an ASIC, and an input and output circuit, which are disposed in an area different from that of the memory cells 3a, 3b, 3c, 3d, 3e, and 3f.

### Reference Sings List

1 semiconductor integrated circuit device
3a, 3b, 3c, 3d, 3e, 3f memory cell
4a, 4b memory gate structure
5a, 5b first select gate structure
6a, 6b second select gate structure
7a, 7b logic gate structure
G1a, G1b memory gate electrode
G2a, G2b first select gate electrode
G3a, G3b second select gate electrode
EC charge storage layer
23a lower gate insulating film
23b upper gate insulating film
Rr1a, Rr1b, Rm1, Rm2, Rm3, Rm4a, Rm4b resist

## Claims

1. A method for producing a semiconductor integrated circuit device comprising a memory circuit region (ER1) and a peripheral circuit region (ER2), the memory circuit region (ER1) including a memory cell in which a memory gate structure (4a, 4b) is disposed between a first select gate structure (5a, 5b) and a second select gate structure (6a, 6b) such that the first and second select gate structures (5a, 5b, 6a, 6b) are separated from the memory gate structure (4a, 4b) by a sidewall spacer (27a), the first select gate structure (5a, 5b) including a first select gate electrode (G2a, G2b), the second select gate structure (6a, 6b) including a second select gate electrode (G3a, G3b), the peripheral circuit region (ER2) including a logic gate structure (7a, 7b) of a peripheral circuit, the method comprising:
a sidewall spacer formation step of forming the memory gate structure (4a, 4b) in the memory circuit region (ER1) and then forming the sidewall spacer (27a) covering the memory gate structure (4a, 4b), the memory gate structure (4a, 4b) including a lower gate insulating film (23a), a charge storage layer (EC), an upper gate insulating film (23b), and a memory gate electrode (G1a, G1b) stacked in this order;
a conductive layer formation step of stacking a gate insulating film (25a,25b, 29a,29b) and a conductive layer (37) in this order in the memory circuit region (ER1) formed with the memory gate structure (4a, 4b) and in the peripheral circuit region (ER2);
a logic gate structure formation step of patterning the conductive layer (37) in the peripheral circuit region (ER2) by using a first resist (Rr1a, Rr1b) patterned by using a photomask, so as to form a logic gate electrode (G5, G6) of the logic gate structure (7a, 7b) on the gate insulating film (29a, 29b), and removing at least a part of the conductive layer (37) in a plurality of select gate electrode cutout planned regions (13a,14a,15a,16a) around the sidewall spacer (27a) in the memory circuit region (ER1) by using the first resist (Rr1a, Rr1b), thereby forming a remaining conductive layer (37a) remaining in the plurality of select gate electrode cutout planned regions (13a,14a,15a,16a); and
a conductive layer patterning step of etching back the conductive layer (37) in the memory circuit region (ER1) while covering the peripheral circuit region (ER2) by using a second resist (Rm4a, Rm4b) patterned by using a photomask to remove the remaining conductive layer (37a) remaining in the plurality of select gate electrode cutout planned regions (13a,14a,15a,16a) while leaving the conductive layer (37) intact along the sidewall spacer (27a), so as to form the first select gate electrode (G2a, G2b) having sidewall-shape and the second select gate electrode (G3a, G3b) having sidewall-shape electrically separated from the first select gate electrode (G2a, G2b) at the plurality of select gate electrode cutout planned regions (13a,14a,15a,16a).

2. The method for producing a semiconductor integrated circuit device according to claim 1, wherein the etching back in the conductive layer patterning step includes anisotropic etching and isotropic etching performed after the anisotropic etching.

3. The method for producing a semiconductor integrated circuit device according to claim 1 or 2, further comprising, before the sidewall spacer formation step:
a first photomask fabrication step of implanting impurities by using a third resist (Rm1) into a portion of the memory circuit region (ER1) where the memory gate structure (4a, 4b) is to be formed, so as to form a channel formation layer, the third resist (Rm1) being patterned by using a first photomask dedicated to fabrication of the memory circuit region (ER1); and
a second photomask fabrication step of forming a memory gate electrode conductive layer (35) on the upper gate insulating film (23b) and then patterning the memory gate electrode conductive layer (35) by using a fourth resist (Rm2), so as to form the memory gate electrode (G1a, G1b), the fourth resist (Rm2) being patterned by using a second photomask dedicated to fabrication of the memory circuit region (ER1), wherein
the conductive layer patterning step includes a photomask processing step of forming the first select gate electrode (G2a, G2b) including a first contact formation conductive layer and the second select gate electrode (G3a, G3b) including a second contact formation conductive layer in the memory circuit region (ER1) by using the second resist (Rm4a, Rm4b) patterned by using a contact formation conductive layer photomask dedicated to fabrication of the memory circuit region (ER1), and
a dedicated photomask process using at least one photomask dedicated to formation of the memory cell in the memory circuit region (ER1) includes a total of three steps, the three steps being the first photomask fabrication step, the second photomask fabrication step, and the photomask processing step.

4. The method for producing a semiconductor integrated circuit device according to claim 3, further comprising, after the sidewall spacer formation step, a third photomask fabrication step of implanting impurities by using a fifth resist (Rm3) into portions of the memory circuit region (ER1) where the first select gate electrode (G2a, G2b) and the second select gate electrode (G3a, G3b) are to be formed, so as to form a channel formation layer on a substrate surface that is to be facing the first select gate electrode (G2a, G2b) and the second select gate electrode (G3a, G3b), the fifth resist (Rm3) being patterned by using a third photomask dedicated to fabrication of the memory circuit region (ER1), wherein
the dedicated photomask process includes a total of four steps, the four steps being the first photomask fabrication step, the second photomask fabrication step, the third photomask fabrication step, and the photomask processing step.

## Patentansprüche

1. Verfahren zur Herstellung einer integrierten Halbleiterschaltungsvorrichtung, die eine Speicherschaltungsregion (ER1) und eine Peripherieschaltungsregion (ER2) umfasst, wobei die Speicherschaltungsregion (ER1) eine Speicherzelle beinhaltet, in der zwischen einer ersten Auswahl-Gate-Struktur (5a, 5b) und einer zweiten Auswahl-Gate-Struktur (6a, 6b) eine Speicher-Gate-Struktur (4a, 4b) derart angeordnet wird, dass die erste und die zweite Auswahl-Gate-Struktur (5a, 5b, 6a, 6b) durch einen Seitenwandabstandshalter (27a) von der Speicher-Gate-Struktur (4a, 4b) getrennt werden, wobei die erste Auswahl-Gate-Struktur (5a, 5b) eine erste Auswahl-Gate-Elektrode (G2a, G2b) beinhaltet, die zweite Auswahl-Gate-Struktur (6a, 6b) eine zweite Auswahl-Gate-Elektrode (G3a, G3b) beinhaltet, die Peripherieschaltungsregion (ER2) eine Logik-Gate-Struktur (7a, 7b) einer Peripherieschaltung beinhaltet, wobei das Verfahren Folgendes umfasst:
einen Schritt des Bildens eines Seitenwandabstandshalters zum Bilden der Speicher-Gate-Struktur (4a, 4b) in der Speicherschaltungsregion (ER1) und dann zum Bilden des Seitenwandabstandshalters (27a), der die Speicher-Gate-Struktur (4a, 4b) bedeckt, wobei die Speicher-Gate-Struktur (4a, 4b) einen unteren Gate-Isolationsfilm (23a), eine Ladungsspeicherschicht (EC), einen oberen Gate-Isolationsfilm (23b) und eine Speicher-Gate-Elektrode (G1a, G1b) beinhaltet, die in dieser Reihenfolgen aufeinander geschichtet sind,
einen Schritt des Bildens einer leitenden Schicht durch Aufeinanderschichten eines Gate-Isolationsfilms (25a, 25b, 29a, 29b) und einer leitenden Schicht (37) in dieser Reihenfolge in der Speicherschaltungsregion (ER1), die mit der Speicher-Gate-Struktur (4a, 4b) gebildet wird, und in der Peripherieschaltungsregion (ER2),
einen Schritt des Bildens einer Logik-Gate-Struktur durch Strukturieren der leitenden Schicht (37) in der Peripherieschaltungsregion (ER2) mit Hilfe eines ersten Fotoresists (Rr1a, Rr1b), strukturiert mit Hilfe einer Fotomaske, so dass auf dem Gate-Isolationsfilm (29a, 29b) eine Logik-Gate-Elektrode (G5, G6) der Logik-Gate-Struktur (7a, 7b) gebildet wird, und Entfernen mindestens eines Teils der leitenden Schicht (37) in mehreren für einen Ausschnitt der Auswahl-Gate-Elektrode vorgesehenen Regionen (13a, 14a, 15a, 16a) um den Seitenwandabstandshalters (27a) in der Speicherschaltungsregion (ER1) herum mit Hilfe des ersten Fotoresists (Rr1a, Rr1b), wodurch eine verbleibende leitende Schicht (37a) gebildet wird, die in den mehreren für einen Ausschnitt der Auswahl-Gate-Elektrode vorgesehenen Regionen (13a, 14a, 15a, 16a) verbleibt, und
einen Schritt des Strukturierens der leitenden Schicht durch Rückätzen der leitenden Schicht (37) in der Speicherschaltungsregion (ER1), während die Peripherieschaltungsregion (ER2) mit Hilfe eines zweiten Fotoresists (Rm4a, Rm4b) bedeckt wird, strukturiert mit Hilfe einer Fotomaske, um die verbliebene leitende Schicht (37a), die in den mehreren für einen Ausschnitt der Auswahl-Gate-Elektrode vorgesehenen Regionen (13a, 14a, 15a, 16a) verbleibt, während die leitende Schicht (37) entlang des Seitenwandabstandshalters (27a) intakt belassen wird, so dass an den mehreren für einen Ausschnitt der Auswahl-Gate-Elektrode vorgesehenen Regionen (13a, 14a, 15a, 16a) die erste Auswahl-Gate-Elektrode (G2a, G2b) mit einer Seitenwandform und die zweite Auswahl-Gate-Elektrode (G3a, G3b) mit einer Seitenwandform, elektrisch von der ersten Auswahl-Gate-Elektrode (G2a, G2b) getrennt, gebildet werden.

2. Verfahren zur Herstellung einer integrierten Halbleiterschaltungsvorrichtung nach Anspruch 1, wobei der Schritt des Strukturierens der leitenden Schicht durch Rückätzen anisotropes Ätzen und isotropes Ätzen, das nach dem anisotropen Ätzen durchgeführt wird, beinhaltet.

3. Verfahren zur Herstellung einer integrierten Halbleiterschaltungsvorrichtung nach Anspruch 1 oder 2, vor dem Schritt des Bildens eines Seitenwandabstandshalters ferner Folgendes umfassend:
einen ersten Schritt der Fotomaskenherstellung durch Implantieren von Unreinheiten mit Hilfe eines dritten Fotoresists (RM1) in einen Abschnitt der Speicherschaltungsregion (ER1), in dem die Speicher-Gate-Struktur (4a, 4b) zu bilden ist, so dass eine Kanalbildungsschicht gebildet wird, wobei das dritte Fotoresist (Rm1) mit Hilfe einer ersten Fotomaske strukturiert wird, die der Herstellung der Speicherschaltungsregion (ER1) zugeordnet ist, und
einen zweiten Schritt der Fotomaskenherstellung durch Bilden einer leitenden Speicher-Gate-Elektrodenschicht (35) auf dem oberen Gate-Isolationsfilm (23b) und dann Strukturieren der leitenden Speicher-Gate-Elektrodenschicht (35) mit Hilfe eines vierten Fotoresists (Rm2), so dass die Speicher-Gate-Elektrode (G1a, G1b) gebildet wird, wobei das vierte Fotoresist (Rm2) mit Hilfe einer zweiten Fotomaske strukturiert wird, die der Herstellung der Speicherschaltungsregion (ER1) zugeordnet ist, wobei:
der Schritt des Strukturierens der leitenden Schicht einen Schritt der Fotomaskenbearbeitung durch Bilden der ersten Auswahl-Gate-Elektrode (G2a, G2b), die eine erste leitende Kontaktbildungsschicht beinhaltet, und der zweiten Auswahl-Gate-Elektrode (G3a, G3b), die eine zweite leitende Kontaktbildungsschicht beinhaltet, in der Speicherschaltungsregion (ER1) mit Hilfe des zweiten Resists (Rm4a, Rm4b), das mit Hilfe der Fotomaske der leitenden Kontaktbildungsschicht strukturiert wird, die der Herstellung der Speicherschaltungsregion (ER1) zugeordnet ist, beinhaltet und
ein zugeordneter Fotomaskenprozess, der mindestens eine Fotomaske verwendet, die dem Bilden der Speicherzelle in der Speicherschaltungsregion (ER1) zugeordnet ist, insgesamt drei Schritte beinhaltet, wobei die drei Schritte der erste Schritt der Fotomaskenherstellung, der zweite Schritt der Fotomaskenherstellung und der Schritt der Fotomaskenbearbeitung sind.

4. Verfahren zur Herstellung einer integrierten Halbleiterschaltungsvorrichtung nach Anspruch 3, nach dem Schritt des Bildens eines Seitenwandabstandshalters ferner Folgendes umfassend:
einen dritten Schritt der Fotomaskenherstellung durch Implantieren von Verunreinigungen mit Hilfe eines fünften Fotoresists (Rm3) in Abschnitte der Speicherschaltungsregion (ER1), wo die erste Auswahl-Gate-Elektrode (G2a, G2b) und die zweite Auswahl-Gate-Elektrode (G3a, G3b) zu bilden sind, so dass auf einer Substratoberfläche, die zur ersten Auswahl-Gate-Elektrode (G2a, G2b) und zur zweiten Auswahl-Gate-Elektrode (G3a, G3b) weisen soll, eine Kanalbildungsschicht gebildet wird, wobei das fünfte Fotoresist (Rm3) mit Hilfe einer dritten Fotomaske strukturiert wird, die der Herstellung der Speicherschaltungsregion (ER1) zugeordnet ist, wobei
der zugeordnete Fotomaskenprozess insgesamt vier Schritte beinhaltet, wobei die vier Schritte der erste Schritt der Fotomaskenherstellung, der zweite Schritt der Fotomaskenherstellung, der dritte Schritt der Fotomaskenherstellung und der Schritt der Fotomaskenbearbeitung sind.

## Revendications

1. Procédé de production d'un dispositif de circuit intégré semi-conducteur comprenant une région de circuit de mémoire (ER1) et une région de circuit périphérique (ER2), la région de circuit de mémoire (ER1) incluant une cellule de mémoire dans laquelle une structure de grille de mémoire (4a, 4b) est disposée entre une première structure de grille de sélection (5a, 5b) et une seconde structure de grille de sélection (6a, 6b) de telle sorte que les première et seconde structures de grille de sélection (5a, 5b, 6a, 6b) sont séparées de la structure de grille de mémoire (4a, 4b) par un espaceur de paroi latérale (27a), la première structure de grille de sélection (5a, 5b) incluant une première électrode de grille de sélection (G2a, G2b), la seconde structure de grille de sélection (6a, 6b) incluant une seconde électrode de grille de sélection (G3a, G3b), la région de circuit périphérique (ER2) incluant une structure de grille logique (7a, 7b) d'un circuit périphérique, le procédé comprenant :
une étape de formation d'espaceur de paroi latérale consistant à former la structure de grille de mémoire (4a, 4b) dans la région de circuit de mémoire (ER1) et puis à former l'espaceur de paroi latérale (27a) couvrant la structure de grille de mémoire (4a, 4b), la structure de grille de mémoire (4a, 4b) incluant un film isolant de grille inférieur (23a), une couche de stockage de charge (EC), un film isolant de grille inférieur (23b) et une électrode de grille de mémoire (G1a, G1b) empilés dans cet ordre ;
une étape de formation de couche conductrice consistant à empiler un film isolant de grille (25a, 25b, 29a, 29b) et une couche conductrice (37) dans cet ordre dans la région de circuit de mémoire (ER1) formée avec la structure de grille de mémoire (4a, 4b) et dans la région de circuit périphérique (ER2) ;
une étape de formation de structure de grille logique consistant à modeler la couche conductrice (37) dans la région de circuit périphérique (ER2) en utilisant une première réserve (Rr1a, Rr1b) modelée en utilisant un photomasque, de sorte à former une électrode de grille logique (G5, G6) de la structure de grille logique (7a, 7b) sur le film isolant de grille (29a, 29b), et à éliminer au moins une partie de la couche conductrice (37) dans une pluralité de régions prévues de découpe d'électrode de grille de sélection (13a, 14a, 15a, 16a) autour de l'espaceur de paroi latérale (27a) dans la région de circuit de mémoire (ER1) en utilisant la première réserve (Rr1a, Rr1b), formant ainsi une couche conductrice restante (37a) restant dans la pluralité de régions prévues de découpe d'électrode de grille de sélection (13a, 14a, 15a, 16a) ; et
une étape de modelage de couche conductrice consistant à graver en retrait la couche conductrice (37) dans la région de circuit de mémoire (ER1) tout en couvrant la région de circuit périphérique (ER2) en utilisant une deuxième réserve (Rm4a, Rm4b) modelée en utilisant un photomasque pour éliminer la couche conductrice restante (37a) restant dans la pluralité de régions prévues de découpe d'électrode de grille de sélection (13a, 14a, 15a, 16a) tout en laissant la couche conductrice (37) intacte le long de l'espaceur de paroi latérale (27a), de sorte à former la première électrode de grille de sélection (G2a, G2b) ayant une forme de paroi latérale et la seconde électrode de grille de sélection (G3a, G3b) ayant une forme de paroi latérale séparée électriquement de la première électrode de grille de sélection (G2a, G2b) au niveau de la pluralité de régions prévues de découpe d'électrode de grille de sélection (13a, 14a, 15a, 16a)

2. Procédé de production d'un dispositif de circuit intégré semi-conducteur selon la revendication 1, dans lequel la gravure en retrait dans l'étape de modelage de couche conductrice inclut la gravure anisotrope et la gravure isotrope effectuée après la gravure anisotrope.

3. Procédé de production d'un dispositif de circuit intégré semi-conducteur selon la revendication 1 ou 2, comprenant en outre, avant l'étape de formation de l'espaceur de paroi latérale :
une première étape de fabrication de photomasque consistant à implanter des impuretés au moyen d'une troisième réserve (Rm1) dans une partie de la région de circuit de mémoire (ER1) où la structure de grille de mémoire (4a, 4b) doit être formée, de sorte à former une couche de formation de canal, la troisième réserve (Rm1) étant modelée en utilisant un troisième photomasque dédié à la fabrication de la région de circuit de mémoire (ER1) ; et
une deuxième étape de fabrication de photomasque consistant à former une couche conductrice d'électrode de grille de mémoire (35) sur le film isolant de grille supérieur (23b) et puis à modeler la couche conductrice d'électrode de grille de mémoire (35) en utilisant une quatrième réserve (Rm2), de sorte à former l'électrode de grille de mémoire (G1a, G1b), la quatrième réserve (Rm2) étant modelée en utilisant un deuxième photomasque dédié à la fabrication de la région de circuit de mémoire (ER1), dans lequel
l'étape de modelage de couche conductrice inclut une étape de traitement de photomasque consistant à former la première électrode de grille de sélection (G2a, G2b) incluant une première couche conductrice de formation de contact et la seconde électrode de grille de sélection (G3a, G3b) incluant une seconde couche conductrice de formation de contact dans la région de circuit de mémoire (ER1) en utilisant la deuxième réserve (Rm4a, Rm4b) modelée en utilisant un photomasque de couche conductrice de formation de contact dédié à la fabrication de la région de circuit de mémoire (ER1), et
un processus de photomasque dédié utilisant au moins un photomasque dédié à la formation de la cellule de mémoire dans la région de circuit de mémoire (ER1) inclut un total de trois étapes, les trois étapes étant la première étape de fabrication de photomasque, la deuxième étape de fabrication de photomasque et l'étape de traitement de photomasque.

4. Procédé de production d'un dispositif de circuit intégré semi-conducteur selon la revendication 3, comprenant en outre, après l'étape de formation d'espaceur de paroi latérale, une troisième étape de fabrication de photomasque consistant à implanter des impuretés en utilisant une cinquième réserve (Rm3) dans des parties de la région de circuit de mémoire (ER1) où la première électrode de grille de sélection (G2a, G2b) et la seconde électrode de grille de sélection (G3a, G3b) doivent être formées, de sorte à former une couche de formation de canal sur une surface de substrat qui doit faire face à la première électrode de grille de sélection (G2a, G2b) et à la seconde électrode de grille de sélection (G3a, G3b), la cinquième réserve (Rm3) étant modelée en utilisant un troisième photomasque dédié à la fabrication de la région de circuit de mémoire (ER1), dans lequel
le processus de photomasque dédié inclut un total de quatre étapes, les quatre étapes étant la première étape de fabrication de photomasque, la deuxième étape de fabrication de photomasque, la troisième étape de fabrication de photomasque et l'étape de traitement de photomasque.
